# EUROPÄISCHE PATENTANMELDUNG

(11) **EP 2 960 315 A1**
(43) Veröffentlichungstag der Anmeldung: **30.12.2015**
(21) Anmeldenummer: 14194116.1
(22) Anmeldetag: 20.11.2014
(51) Int. Cl.: C09K 11/06, C07F 1/08, H01L 51/50

(54) **Organische Elektrolumineszenzvorrichtung**

(30) Priorität: 27.06.2014 EP 14230007
(71) Anmelder: cynora GmbH, 76646 Bruchsal (DE)
(72) Erfinder: Baumann, Thomas, Dr., 76133 Karlsruhe (DE); Volz, Daniel, Dr., 76137 Karlsruhe (DE); Flügge, Harald, Dr., 76135 Karlsruhe (DE); Fléchon, Charlotte, Dr., 76646 Bruchsal (DE); Jakob, Andreas, Dr., 76137 Karlsruhe (DE); Navarro, José Miguel, Dr., 67480 Roeschwoog (FR)
(74) Vertreter: Hoppe, Georg Johannes

(57) **Zusammenfassung**

Die Erfindung betrifft die Verwendung eines Metall(I)komplexes der Formel A 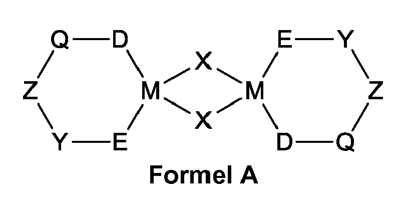 mit M = unabhängig voneinander ausgewählt aus der Gruppe bestehend aus Cu und Ag;
X = unabhängig voneinander ausgewählt aus der Gruppe bestehend aus CI, Br, I, CN, OCN, SCN, Alkinyl und N₃;
E∩D = unabhängig voneinander ein zweizähniger Ligand mit
E = RR'E* (wenn E* = N, P, As, Sb) oder RE* (wenn E* = C*, O, S) mit E* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl-, Heteroalkyl-, Aryl-, Heteroaryl-, Alkenyl-, Alkinyl-Gruppen bzw. substituierte Alkyl-, Heteroalkyl-, Aryl-, Heteroaryl- und Alkenyl-Gruppen (mit Substituenten wie Halogene oder Deuterium, Alkylgruppen, Heteroalkyl-, Aryl-, Heteroarylgruppen), und weitere allgemein bekannte Donor- und Akzeptor-Gruppen und CF₃-Gruppen;
D = RR'D* (wenn D* = N, P, As, Sb) oder RD* (wenn D* = C*, O, S) mit D* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl-, Heteroalkyl-, Aryl-, Heteroaryl-, Alkenyl-, Alkinyl-Gruppen bzw. substituierte Alkyl-, Heteroalkyl-, Aryl-, Heteroaryl- und Alkenyl-Gruppen (mit Substituenten wie Halogene oder Deuterium, Alkylgruppen, Heteroalkyl-, Aryl-, Heteroarylgruppen), und weitere allgemein bekannte Donor- und Akzeptor-Gruppen, und CF₃-Gruppen;
wobei D und E verschieden voneinander sind;
"∩" = eine dreiteilige Einheit aus Q, Y und Z, die miteinander verbunden sind und unabhängig voneinander ausgewählt sind aus der Gruppe bestehend aus NR, O, S und PR sowie Alkyl-, Heteroalkyl-, Aryl-, Heteroaryl-, Alkenyl-, Alkinyl-Gruppen bzw. substituierte Alkyl-, Heteroalkyl-, Aryl-, Heteroaryl- und Alkenyl-Gruppen mit Substituenten wie Halogene oder Deuterium, Alkylgruppen, Heteroalkyl-, Aryl-, Heteroaryl und weitere allgemein bekannte Donor- und Akzeptor-Gruppen, wie beispielsweise Amine, Carboxylate und deren Ester, und CF₃-Gruppen; sowie ihre Verwendung in optoelektronischen Bauelementen, insbesondere in OLEDs.

## Beschreibung

Die vorliegende Anmeldung betrifft die Verwendung von lumineszierenden Metall(I)komplexen zur Herstellung von organischen Elektrolumineszenzvorrichtungen (optoelektronischen Bauelementen), sowie damit erhaltbare organische Elektrolumineszenzvorrichtungen.

### Hintergrund

Der Aufbau organischer Elektrolumineszenzvorrichtungen (z. B. OLEDs), in denen organische Halbleiter als funktionelle Materialien eingesetzt werden, ist beispielsweise in der US 4539507, der US 5151629, der EP 0676461 und der WO 98/27136 A beschrieben. Dabei werden als emittierende Materialien zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie und Leistungseffizienz möglich. Im Stand der Technik werden in phosphoreszierenden OLEDs meist einkernige Iridium- oder Platinkomplexe als Triplettemitter eingesetzt. Bei diesen Verbindungen existiert Verbesserungsbedarf, insbesondere hinsichtlich einer einfacherer Herstellung der Organischen Elektrolumineszenzvorrichtungen.

### Beschreibung der Erfindung

Die Erfindung betrifft in einem Aspekt organische Elektrolumineszenzvorrichtungen (optoelektronische Bauelemente), die durch Vakuumverdampfung hergestellt werden können. Überraschend wurde gefunden, dass bestimmte organische Elektrolumineszenzvorrichtungen enthaltend die unten näher beschriebenen dimeren Metallkomplexe eine einfachere Herstellung von organischen Elektrolumineszenzvorrichtungen ermöglichen. Diese Metallkomplexe eignen sich sehr gut für die Verwendung als verdampfbare Emitter in einer Emissionsschicht oder Absorptionsschicht und führen zu Verbesserungen der organischen Elektrolumineszenzvorrichtung, insbesondere hinsichtlich der Effizienz. Dies gilt insbesondere für grüne und blaue Elektrolumineszenzvorrichtungen, die auf dem Prinzip des Singulett-Harvesting (thermisch aktivierte verzögerte Fluoreszenz) basieren. Organische Elektrolumineszenzvorrichtungen, welche diese Komplexe enthalten, betreffen daher einen Aspekt der Erfindung.

Die Neutralität der erfindungsgemäßen Metall(I)komplexe, insbesondere der Kupfer(I)-Komplexe aufweisend eine Struktur gemäß den Formeln I bis IX, wird gewährleistet, da beide Cu(I)-lonen einfach positiv und die zwei überbrückenden Liganden X, die jeweils an beide Cu(I)-Ion gebunden sind, einfach negativ geladen sind. Die erfindungsgemäßen zweikernigen neutralen Metall(I)komplexe, insbesondere in Form von Kupfer(I)-Komplexen, weisen demgemäß zwei einfach negativ geladene überbrückende Liganden X und zwei neutrale bidentate Liganden EnD, die über je zwei Donoratome an ein Cu(I)-Ion koordinieren, auf.

Gegenstand der Erfindung ist somit in einem Aspekt eine organische Elektrolumineszenzvorrichtung, enthaltend mindestens eine Verbindung mit einer Struktur der Formel A:

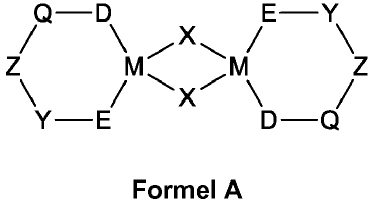

In Formel A (nachfolgend auch als M₂X₂(E∩D)₂ bezeichnet) steht EnD unabhängig voneinander für einen zweizähnigen chelatisierenden Liganden, der über ein Donoratom D* und ein Donoratom E*, die unabhängig voneinander ausgewählt sind aus der Gruppe bestehend aus N, wobei N kein Imin-Stickstoffatom oder Teil eines N-heteroaromatischen Rings ist, P, C*, O, S, As und Sb an den M₂X₂-Kern bindet, wobei die beiden Donoratome D* und E* verschieden voneinander sind und durch die drei Einheiten Q, Y, Z verbunden sind und somit einen zweizähnigen Liganden ergeben, und wobei in einer bevorzugten Ausführungsform die folgenden Kombinationen aus D* und E* zulässig sind:

| | | | | | | | | | | | | | | |
|---|---|---|---|---|---|---|---|---|---|---|---|---|---|---|
| D* = | N | N | N | N | N | N | P | P | P | P | P | C* | C* | C* |
| E* = | P | C* | O | S | As | Sb | N | C* | O | As | Sb | N | P | O |
| | | | | | | | | | | | | | | |
| D* = | C* | C* | C* | O | O | O | O | O | O | S | S | S | S | S |
| E* = | S | As | Sb | N | P | C* | S | As | Sb | N | C* | O | As | Sb |
| | | | | | | | | | | | | | | |
| D*= | As | As | As | As | As | As | Sb | Sb | Sb | Sb | Sb | Sb | | |
| E* = | N | P | C* | O | S | Sb | N | P | C* | O | S | As | | |

X steht unabhängig voneinander für Cl, Br, I, CN, OCN, SCN, Alkinyl und/oder N₃, M steht unabhängig voneinander für Cu und Ag. C* steht für ein divalentes Carben-Kohlenstoffatom. Bei n handelt es sich um eine dreiteilige Einheit aus Q, Y und Z, die miteinander verbunden sind und unabhängig voneinander ausgewählt sind aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen. Beide Liganden EnD können auch weiter substituiert und/oder anneliert und/oder auch miteinander verbunden sein, so dass sich ein vierzähniger Ligand ergibt.

Q ist sowohl mit D als auch mit Z verbunden, wobei eine erste Bindung zwischen einem Atom Q* des Substituenten Q und einem Atom D* des Substituenten D ausgebildet wird, und wobei eine zweite Bindung zwischen einem Atom Q* des Substituenten Q und einem Atom Z* des Substituenten Z ausgebildet wird. Analoges gilt für Y, eine erste Bindung wird zwischen einem Atom Y* des Substituenten Y und einem Atom E* des Substituenten E ausgebildet, und eine zweite Bindung zwischen einem Atom Y* des Substituenten Y und einem Atom Z* des Substituenten Z ausgebildet. Analoges gilt für Z, eine erste Bindung wird zwischen einem Atom Z* des Substituenten Z und einem Atom Q* des Substituenten Q* ausgebildet, und eine zweite Bindung zwischen einem Atom Z* des Substituenten Z und einem Atom Y* des Substituenten Y ausgebildet. Q*, Y* und Z* sind unabhängig voneinander ausgewählt aus der Gruppe bestehend aus C, N, O, S und P.

Folgende Kombinationen direkt benachbarter Atome D*, E*, Q*, Y* und Z* sind in einer Ausführungsform der Erfindung nicht zulässig: P-N, N-As, N-Sb, O-O, P-P, P-As, P-Sb.

Jedes R ist unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind.

Aus der Unterschiedlichkeit von D und E resultiert ein unsymmetrischer Ligand und daraus folglich ein Komplex mit sehr niedriger Symmetrie (wenig Symmetrieoperationen möglich), der im Gegensatz zu hoch-symmetrischen Komplexen (viele Symmetrieoperationen möglich) eine sehr geringe Neigung hat zu kristallisieren. Da Materialien für optoelektronische Vorrichtungen wie OLEDs amorphe Schichten ausbilden müssen, da polykristalline Bereiche gebildete Excitonen strahlungslos löschen, sind Verbindungen mit einer hohen Kristallinität ungeeignet, da hierbei Entmischungseffekte und Konzentrationsquenching auftreten können. In nicht stabilen Filmen, die während des Betriebs der OLED kristallisieren, können die Korngrenzen der Kristalle als Fallenzustände agieren. Daher ist ein wichtiges Kriterium für die Entwicklung organischer Funktionsmaterialien optoelektronischer Vorrichtungen wie OLEDs die Beständigkeit des amorphen Zustandes. Thermische Beanspruchung während des Betriebes einer OLED kann zu einem Übergang des metastabilen amorphen Zustandes zum thermodynamisch stabilen Kristall führen. Dies hat weitreichende Konsequenzen für die Lebensdauer des Bauteiles. Die Korngrenzen einzelner Kristallite stellen Fehlstellen dar, an denen der Transport von Ladungsträgern zum Erliegen kommt. Ebenso führt die mit der Kristallisation einhergehende Umstrukturierung der Schichten zu einem verminderten Kontakt der Schichten untereinander und mit den Elektroden. Dies führt beim Betrieb mit der Zeit zum Auftreten von dunklen Stellen ("dark spots") und letztlich zur Zerstörung der OLED.

Somit lag der vorliegenden Erfindung die Aufgabe zu Grunde, oben genannte Nachteile bei Verwendung symmetrischer und dadurch leichter kristallisierbarer Komplexe zu überwinden und Emittermaterialien bereitzustellen, die aufgrund ihrer deutlich geringeren Symmetrie diese nachteiligen Eigenschaften nicht aufweisen. Der Ligand EnD ist optional substituiert, insbesondere mit funktionellen Gruppen, die den Ladungsträgertransport verbessern.

Spezielle Ausführungsformen der erfindungsgemäßen zweikernigen Metall(I)komplexe der Formel A werden durch die Verbindung der Formeln I bis IX dargestellt und im Folgenden erläutert. 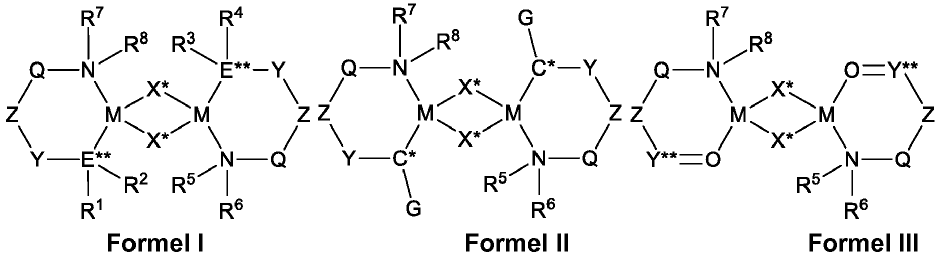 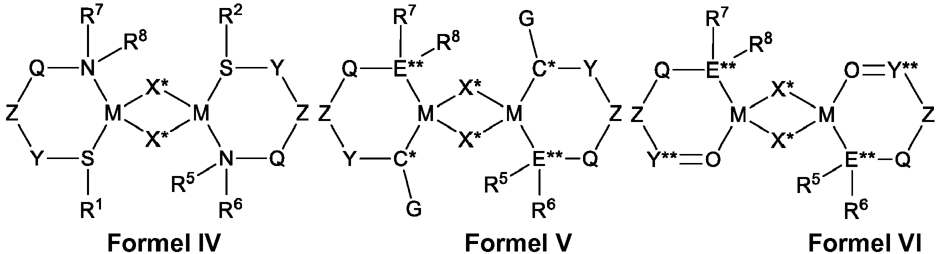 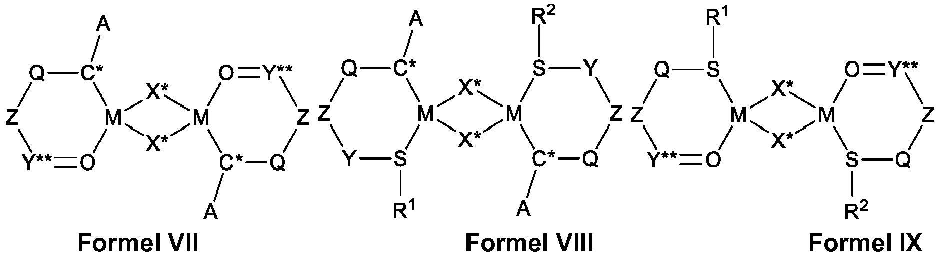 mit:
X* = unabhängig voneinander ausgewählt aus der Gruppe bestehend aus Cl, Br, I, CN, OCN, SCN, Alkinyl und N₃;
M = unabhängig voneinander ausgewählt aus der Gruppe bestehend aus Cu und Ag;
E** = unabhängig voneinander ausgewählt aus der Gruppe bestehend aus P, As und Sb;
C* = ein divalentes Carben-Kohlenstoffatom;
A und G = unabhängig voneinander Substituenten ausgewählt aus der Gruppe bestehend aus NRR', OR, SR und PRR' sowie Alkyl- (auch verzweigt oder zyklisch), Heteroalkyl-, Aryl-, Heteroaryl-, Alkenyl-, Alkinyl-Gruppen bzw. substituierte Alkyl-(auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Q, Y und Z = unabhängig voneinander Substituenten ausgewählt aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl-(auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Y** = unabhängig voneinander ausgewählt aus der Gruppe bestehend aus CR, N, PRR', SR, S(O)R;
R und R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R¹-R⁸ = jeweils unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind. Die Reste R¹-R⁸ können optional auch zu annelierten Ringsystemen führen.

Die Einheiten QC*A und YC*G sind in einer Ausführungsform unabhängig voneinander ausgewählt aus der Gruppe bestehend aus: 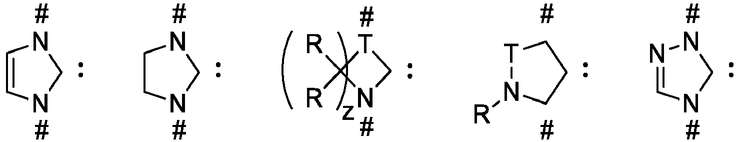 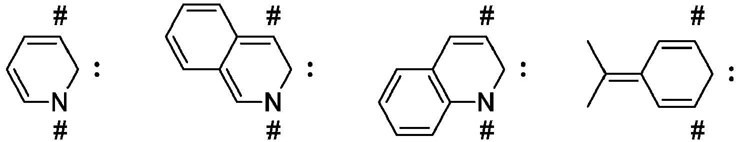 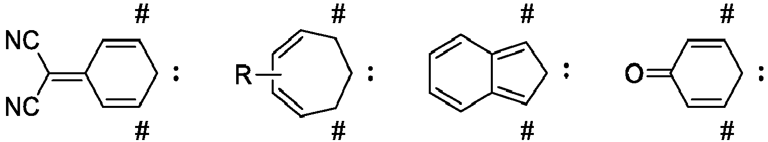 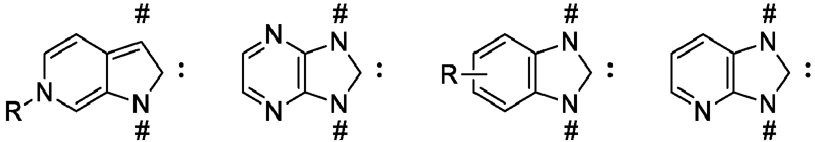
wobei die zwei Punkte ":" für ein divalentes Carben-Kohlenstoffatom stehen, das an das Metall koordiniert, und die Verknüpfung von Q mit Z und die Verknüpfung von Y mit Z an einer der mit # gekennzeichneten Stellen stattfindet und somit A und G das andere Nachbaratom des Carben-Kohlenstoffatoms darstellt, das dann mit einem Rest R substituiert ist, der ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
jedes weitere R ist unabhängig voneinander ebenfalls ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
T ausgewählt ist aus der Gruppe bestehend aus CR₂, NR und SR, wobei jedes R unabhängig voneinander ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
und z für die ganzen Zahlen 1, 2, 3 oder 4 steht.

Der zweizähnige Ligand EnD ist in einer Ausführungsform substituiert, insbesondere mit funktionellen Gruppen, die den Ladungsträgertransport verbessern.

Durch die Koordination der zweizähnigen Liganden EnD wird die Stabilität und Rigidität des Metall(I)komplexes stark erhöht. Der große Vorteil bei der Verwendung von Kupfer als Zentralmetall ist dessen niedriger Preis, v. a. im Vergleich zu den sonst bei OLED-Emittern üblichen Metallen wie Re, Os, Ir und Pt. Zusätzlich spricht auch die geringe Toxizität des Kupfers für dessen Verwendung.

Hinsichtlich ihrer Verwendung in optoelektronischen Bauelementen zeichnen sich die erfindungsgemäßen Metall(I)komplexe durch einen weiten Bereich von erzielbaren Emissionsfarben aus. Zudem ist die Emissionsquantenausbeute hoch, insbesondere größer als 50 %. Für Emitterkomplexe mit Cu-Zentralion sind die Emissionsabklingzeiten erstaunlich kurz.
Außerdem sind die erfindungsgemäßen Metall(I)komplexe in relativ hohen Emitterkonzentrationen ohne deutliche Quencheffekte verwendbar. Das heißt, im Emitter-Layer können Emitterkonzentrationen von 5 % bis 100 % verwendet werden.

Bevorzugt handelt es sich bei dem Liganden EnD in den Formeln I bis IX um folgende Liganden: 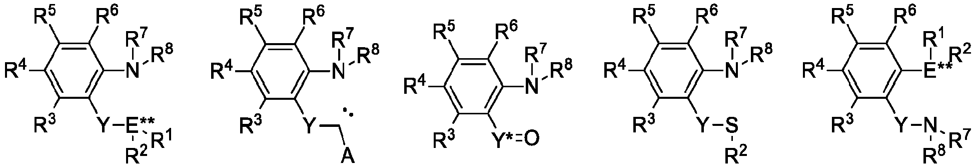 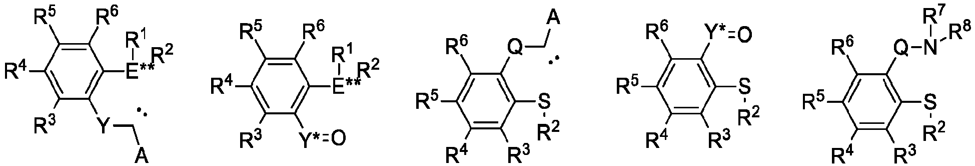 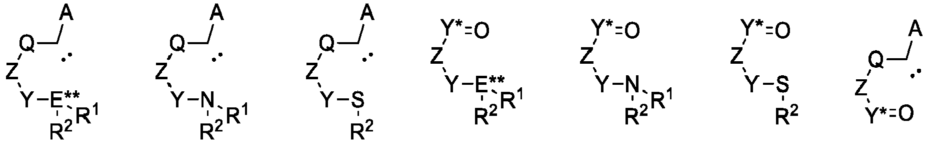 mit
E** = ausgewählt aus der Gruppe bestehend aus P, As und Sb,
: = ein Carben-Kohlenstoffatom,
A = unabhängig voneinander Substituenten ausgewählt aus der Gruppe bestehend aus NRR', OR, SR und PRR' sowie Alkyl- (auch verzweigt oder zyklisch), Heteroalkyl-, Aryl-, Heteroaryl-, Alkenyl-, Alkinyl-Gruppen bzw. substituierte Alkyl-(auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Q, Y und Z = unabhängig voneinander Substituenten ausgewählt aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl-(auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
A und Q und G und Y können optional jeweils miteinander verbunden sein, sodass sich ein Imidazolidin- oder ein Imidazolderivat ausbildet und/oder mit der Einheit Z und/oder den Resten R³-R⁸ auch zu annelierten Ringsystemen führen,
Y* = unabhängig voneinander ausgewählt aus der Gruppe bestehend aus CR, N, PRR', SR, S(O)R;
R und R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R¹-R⁸ können jeweils unabhängig voneinander ausgewählt aus der Gruppe bestehend aus Wasserstoff, Halogen sein und Substituenten, die direkt oder über Sauerstoff- (-OR), Stickstoff- (-NR₂) oder Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind. R³-R⁸ können optional auch zu annelierten Ringsystemen führen.

Die Erfindung betrifft auch ein Verfahren zur Herstellung eines erfindungsgemäßen Metall(I)komplexes. Dieses erfindungsgemäße Verfahren weist den Schritt des Durchführens einer Reaktion des zweizähnigen Liganden EnD mit M(I)X auf,
wobei
M = unabhängig voneinander ausgewählt aus der Gruppe bestehend aus Cu und Ag,
X = unabhängig voneinander ausgewählt aus der Gruppe bestehend aus Cl, Br, I, CN, OCN, SCN, Alkinyl und N₃,
E∩D = ein zweizähniger Ligand mit
E = RR'E* (wenn E* = N, P, As, Sb) oder RE* (wenn E* = C*, O, S) mit E* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
D = RR'D* (wenn D* = N, P, As, Sb) oder RD* (wenn D* = C*, O, S) mit D* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
wobei D und E verschieden voneinander sind
"∩" = eine dreiteilige Einheit aus Q, Y und Z, die miteinander verbunden sind und unabhängig voneinander ausgewählt sind aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind. R ist unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind.

Die Reaktion wird bevorzugter Weise in Dichlormethan (DCM) durchgeführt, wobei auch andere organische Lösungsmittel wie Acetonitril oder Tetrahydrofuran oder Dimethylsulfoxid oder Ethanol verwendet werden können. Durch die Zugabe von Diethylether oder Hexan oder Methyl-tert-butylether oder Pentan oder Methanol oder Ethanol oder Wasser zum gelösten Produkt kann ein Feststoff gewonnen werden. Letzteres kann durch Fällung oder Eindiffusion oder in einem Ultraschall-Bad durchgeführt werden.
Bei der Reaktion von zweizähnigen E∩D-Liganden mit M(I)X (M = Ag, Cu; X = Cl, Br, I), bevorzugt in Dichlormethan (DCM), bevorzugt bei Raumtemperatur, entsteht der zweikernige 2:2-Komplex M₂X₂(E∩D)₂, in dem jedes Metallatom durch je einen Liganden zweifach koordiniert sowie die beiden Halogenid-Anionen überbrückt wird (Gl. 1).

Die Struktur der Formel A ist verwandt mit bekannten Komplexen der Form Cu₂X₂L₂L' bzw. Cu₂X₂L₄. Im Gegensatz zu Cu₂X₂L₄ mit vier einzähnigen Liganden L (L = PR₃ oder Pyridin, X = Cl, Br, oder I) ist die Stabilität des hier beschriebenen Komplexes durch Verwendung von zwei zweizähnigen Liganden der Form EnD viel größer (erkennbar beispielsweise durch Absorptions- und Emissionsmessungen des Komplexes in Lösung und als Filme) und zusätzlich die Rigidität des Komplexes stark erhöht. Der Komplex kann durch Fällen mit Et₂O als gelbes oder rotes mikrokristallines Pulver isoliert werden. Einkristalle können durch langsames Eindiffundieren von Et₂O in die Reaktionslösung erhalten werden. Sobald die Komplexe als Pulver oder Kristalle vorliegen, sind sie in gängigen organischen Lösungsmitteln teilweise schwer löslich bis unlöslich. Insbesondere bei niedrigen Löslichkeiten wurden Komplexe nur durch Elementar- und Röntgenstrukturanalysen identifiziert.

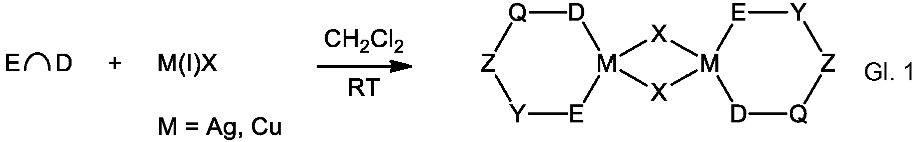

Hierbei handelt es sich um die oben aufgeführte allgemeine Formel A. Der zweizähnige E∩D-Ligand kann mindestens einen Rest R umfassen, der jeweils unabhängig voneinander ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen. Die Substituenten können auch zu anellierten Ringsystemen führen.

Zur Verwendung der Metall(I)-Komplexe als selbstkatalysierende Emittermaterialien zur Erzielung einer Quervernetzung mit einem zweiten Reaktanden können solche Funktionalitäten in der Peripherie des E∩D-Liganden angebracht werden, die mit der entsprechend komplementären funktionellen Einheit des zweiten Reaktanden eine durch den Metall(I)-Komplex katalysierte Quervernetzung und somit Immobilisierung ermöglichen. Zusätzlich sorgt diese Quervernetzung für eine Stabilisierung und Fixierung der geometrischen Struktur der Metallkomplexe, wodurch eine Bewegung der Liganden und somit eine Strukturänderung der angeregten Moleküle verhindert und eine Effizienzminderung durch strahlungslose Relaxationspfade wirkungsvoll unterbunden wird.

Beispielhaft für eine selbstkatalysierte Quervernetzungsreaktion ist die Kupferkatalysierte Click-Reaktion zwischen einem terminalen oder aktivierten Alkin als erster Click-Gruppe und einem Azid als zweiter Click-Gruppe. Da der Metallkomplex-Emitter in dieser Ausführungsform mindestens zwei Alkin-Einheiten tragen muss, sind mindestens zwei der Einheiten D, E, Q, Y, Z in bevorzugter Weise mit mindestens je einer der oben genannten funktionellen Gruppe zur Erzielung einer Quervernetzung substituiert. Erfindungsgemäß sind auch Metall(I)komplexe, die durch ein derartiges Syntheseverfahren herstellbar sind.

Die erfindungsgemäßen Metall(I)komplexe können als Emitter-Materialien in einer Emitterschicht eines Licht-emittierenden optoelektronischen Bauelements eingesetzt werden. Die Metall(I)komplexe können auch als Absorber-Materialien in einer Absorberschicht eines optoelektronischen Bauelements eingesetzt werden.

Unter der Bezeichnung "optoelektronische Bauelemente" bzw. "organischen Elektrolumineszenzvorrichtungen" werden insbesondere verstanden:
- Organische Licht-emittierende Bauteile (organic light emitting diodes, OLEDs),
- Licht-emittierende elektrochemische Zellen (light emitting electrochemical cells, LECs, LEECs),
- OLED-Sensoren, insbesondere in nicht hermetisch nach außen abgeschirmten Gas- und Dampf-Sensoren,
- organische Solarzellen (organic solar cells, OSCs, organic photovoltaics, OPVs),
- Organische Feldeffekttransistoren und
- Organische Laser.

Der Anteil des Metall(I)komplexes in der Emitter- oder Absorber-Schicht in einem derartigen optoelektronischen Bauelement beträgt in einer Ausführungsform der Erfindung 100 %. In einer alternativen Ausführungsform beträgt der Anteil des Metall(I)komplexes in der Emitter- oder Absorber-Schicht 1 % bis 99 %.
Vorteilhafter Weise beträgt die Konzentration des Metall(I)komplexes als Emitter in optischen Licht emittierenden Bauelementen, insbesondere in OLEDs, zwischen 5 % und 80 %.

Gegenstand der vorliegenden Erfindung sind auch optoelektronische Bauelemente, die einen hier beschriebenen Metall(I)komplex aufweisen. Dabei kann das optoelektronische Bauelement ausgeformt sein als ein organisch lichtemittierendes Bauelement, eine organische Diode, eine organische Solarzelle, ein organischer Transistor, als eine organische Licht-emittierende Diode, eine Licht-emittierende elektrochemische Zelle, ein organischer Feldeffekttransistor und als ein organischer Laser.

Weiterhin betrifft die vorliegende Erfindung ein Verfahren zur Herstellung eines optoelektronischen Bauelements, wobei ein erfindungsgemäßer Metall(I)komplex der hier beschriebenen Art verwendet wird. Bei diesem Verfahren wird insbesondere ein erfindungsgemäßer Metall(I)komplex auf einen Träger aufgebracht. Dieses Aufbringen kann mittels Sublimation erfolgen.

Die vorliegende Erfindung betrifft auch ein Verfahren zur Veränderung der Emissions- und/oder Absorptionseigenschaften eines elektronischen Bauelements. Dabei wird ein erfindungsgemäßer Metall(I)komplex in ein Matrixmaterial zur Leitung von Elektronen oder Löchern in ein optoelektronisches Bauelement eingebracht.

Die vorliegende Erfindung betrifft auch die Verwendung eines erfindungsgemäßen Metall(I)komplexes, insbesondere in einem optoelektronischen Bauelement, zur Umwandlung von UV-Strahlung oder von blauem Licht in sichtbares Licht, insbesondere in grünes (490-575 nm), gelbes (575-585 nm), oranges (585-650 nm) oder rotes Licht (650-750 nm) (Down-Konversion).

In einer bevorzugten Ausführungsform ist die optoelektronische Vorrichtung eine Weißlicht-OLED, wobei der erste Emitterkomplex ein Rotlichtemitter ist, der zweite Emitterkomplex ein Grünlichtemitter ist und der dritte Emitterkomplex ein Blaulichtemitter ist. Der erste, zweite und/oder dritte Emitterkomplex ist bevorzugt ein erfindungsgemäßer Metall(I)komplex.

Ein weiterer Aspekt der Erfindung betriff die Veränderung der Emissionsfarben der Metall(I)komplexe mittels elektronenschiebender oder -ziehender Substituenten oder mittels kondensierter N-Heteroaromaten. Die Begriffe elektronenschiebend und elektronenziehend sind dem Fachmann bekannt.

Beispiele für elektronenschiebende Substituenten sind insbesondere:
-Alkyl, -Phenyl, -CO₂(-), -O(-), -NH-Alkylgruppe, -N-(Alkylgruppe)₂, -NH₂, -OH, -O-Alkylgruppe, -NH(CO)-Alkylgruppe, -O(CO)-Alkylgruppe, -O(CO)-Arylgruppe, - O(CO)-Phenylgruppe, -(CH)=C-(Alkylgruppe)₂, -S-Alkylgruppe

Beispiele für elektronenziehende Substituenten sind insbesondere:
-Halogen, -(CO)H, -(CO)-Alkylgruppe, -(CO)O-Alkylgruppe, -(CO)OH, - (CO)Halogenid, -CF₃, -CN, -SO₃H, -NH₃(+), -N(Alkylgruppe)₃(+), -NO₂

Vorteilhafter Weise sind die elektronenschiebenden und -ziehenden Substituenten möglichst weit von der Koordinationsstelle des Liganden entfernt.

Somit kann durch geeignete Substitutionswahl innerhalb der Grundstruktur eines E∩D-Liganden ein sehr breiter Emissionsfarbbereich eingestellt werden.
Die Veränderung der Emissionsfarben der hier beschriebenen Metall(I)komplexe kann auch durch weitere Heteroatome wie N, O, S, sowie mittels kondensierter Aromaten erfolgen.
Die Verwendung kondensierter Aromaten wie beispielsweise Naphthyl, Anthracenyl, Phenanthrenyl etc. ermöglicht Farbverschiebungen, zum Beispiel in den gelben bis tiefroten Spektralbereich.

Da die beschriebenen Substanzen auch als Feststoffe eine hohe Emissionsquantenausbeute besitzen, können sie ausgehend von der Reaktionslösung auch direkt als dünne Schicht (100 % Emitterschicht) auf dem Substrat abgeschieden werden.

Unter einer organischen Elektrolumineszenzvorrichtung im Sinne dieser Erfindung wird eine Elektrolumineszenzvorrichtung verstanden, welche Anode, Kathode und mindestens eine emittierende Schicht enthält, wobei mindestens eine Schicht, welche zwischen Anode und Kathode angeordnet ist, mindestens eine organische oder metallorganische Verbindung bzw. mindestens eine Metallkoordinationsverbindung enthält. Die erfindungsgemässe organische Elektrolumineszenzvorrichtung enthält also Anode, Kathode und mindestens eine emittierende Schicht, wobei mindestens eine Schicht mindestens eine Verbindung der oben aufgeführten Formel A enthält. Weiterhin finden in der vorliegenden Anmeldung die folgenden Definitionen Anwendung:
Eine Arylgruppe im Sinne dieser Erfindung enthält 6 bis 40 C-Atome; eine Heteroarylgruppe im Sinne dieser Erfindung enthält 2 bis 39 C-Atome und mindestens ein Heteroatom, mit der Massgabe, dass die Summe aus C-Atomen und Heteroatomen mindestens 5 und höchstens 40 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein cyclisches Carben im Sinne dieser Erfindung ist eine cyclische Gruppe, welche über ein neutrales C-Atom an das Metall bindet. Dabei kann die cyclische Gruppe gesättigt oder ungesättigt sein. Bevorzugt sind hierbei Arduengo-Carbene, also solche Carbene, bei welchen an das Carben-C- Atom zwei Stickstoffatome gebunden sind. Dabei wird ein Fünfring-Arduengo-Carben bzw. ein anderes ungesättigtes Fünfring-Carben ebenfalls als eine Arylgruppe im Sinne dieser Erfindung angesehen. Unter einer Aralkylgruppe im Sinne der vorliegenden Erfindung werden Alkylgruppen verstanden, insbesondere die unten aufgeführten Alkylgruppen, welche mit einer Aryl- oder Heteroarylgruppe, insbesondere einer der unten aufgeführten Aryl- oder Heteroarylgruppen, substituiert sind.

Ein aromatisches Ringsystem im Sinne dieser Erfindung enthält 6 bis 60 C-Atome im Ringsystem. Ein heteroaromatisches Ringsystem im Sinne dieser Erfindung enthält 2 bis 59 C-Atome und mindestens ein Heteroatom im Ringsystem, mit der Maßgabe, dass die Summe aus C-Atomen und Heteroatomen mindestens 5 und höchstens 60 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit, wie z. B. ein sp³-hybridisiertes C-, N- oder O-Atom, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind.

Im Rahmen der vorliegenden Erfindung werden unter einer C1- bis C40- Alkylgruppe bzw. C1- bis C20-Alkylgruppe, in der auch einzelne H-Atome oder CH2-Gruppen durch die oben genannten Gruppen substituiert sein können, beispielsweise die Reste Methyl, Ethyl, n-Propyl, i-Propyl, n-Butyl, i-Butyl, s-Butyl, t-Butyl, 2-Methylbutyl, n-Pentyl, s-Pentyl, t-Pentyl, 2-Pentyl, Cyclopentyl, n-Hexyl, s-Hexyl, t-Hexyl, 2-Hexyl, 3-Hexyl, Cyclohexyl, 2- Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Trifluormethyl, Pentafluorethyl oder 2,2,2-Trifluorethyl verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Heptenyl, Cycloheptenyl, Octenyl oder Cyclooctenyl verstanden. Unter einer Alkinylgruppe werden beispielsweise Ethinyl, Propinyl, Butinyl, Pentinyl, Hexinyl, Heptinyl oder Octinyl verstanden. Unter einer C1- bis C40- Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Phenanthren, Benzanthracen, Pyren, Chrysen, Perylen, Fluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3- Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Im Folgenden werden die Ausführungsformen der Verbindung gemäss Formel A beschrieben, wie sie bevorzugt in der organischen Elektrolumineszenzvorrichtung verwendet wird.

Die Neutralität der Kupfer(I)-Komplexe der Formeln I bis IX wird gewährleistet, da beide Cu(I)-Ionen einfach positiv und die zwei überbrückenden Liganden X, die jeweils an beide Cu(I)-Ion gebunden sind, einfach negativ geladen sind. Die erfindungsgemäßen zweikernigen neutralen Kupfer(I)- Komplexe weisen demgemäß zwei einfach negativ geladene überbrückende Liganden X und zwei neutrale bidentate Liganden EnD, die über je zwei Donoratome an ein Cu(I)-Ion koordinieren, auf.

Die Liganden X sind bevorzugt monoanionische überbrückende Liganden, die jeweils an beide Metall(I)-Ionen gebunden sind. Die Liganden EnD sind bidentat, weisen also zwei Koordinationsstellen auf, und koordinieren mit beiden Koordinationsstellen an dasselbe Metall M<1> oder M<2>.
Geeignete monoanionische Liganden X sind ausgewählt aus den Halogeniden Cl, Br und I, Azid, Alkylacetyliden, wie z. B. Methyl-C=C-, tert-Butyl- C=C-, Aryl- bzw. Heteroarylacetyliden, wie z. B. Phenyl-C=C-, Cyanid, Cyanat, Isocyanat, Thiocyanat, Isothiocyanat. Dabei sind die Alkylgruppen in diesen Gruppen bevorzugt C1-C20-Alkylgruppen, besonders bevorzugt C1-C10-Alkylgruppen, ganz besonders bevorzugt C1-C4-Alkylgruppen. Unter einer Arylgruppe werden auch Heteroarylgruppen verstanden. Diese Gruppen sind wie oben definiert.

Die oben beschriebenen Komplexe gemäß Formel A bzw. die oben aufgeführten bevorzugten Ausführungsformen werden in der organischen Elektrolumineszenzvorrichtung als aktive Komponente verwendet. Aktive Komponenten sind generell die organischen, metallorganischen oder anorganischen Materialien, welche zwischen Anode und Kathode eingebracht sind, beispielsweise Ladungsinjektions-, Ladungstransport- oder Ladungsblockiermaterialien, Emissionsmaterialien und Matrixmaterialien. Insbesondere als Emissionsmaterialien zeigen die erfindungsgemässen Verbindungen besonders gute Eigenschaften, wie im Folgenden noch näher ausgeführt wird. Eine bevorzugte Ausführungsform der Erfindung sind daher organische Elektrolumineszenzvorrichtungen enthaltend mindestens eine Verbindung gemäß Formel A in einer Emissionsschicht.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Ladungserzeugungsschichten (Charge Generation Layers) und/oder organische oder anorganische p/n-Übergänge. Ebenso können zwischen zwei emittierende Schichten Interlayers eingebracht sein, welche beispielsweise eine Exzitonen-blockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten, wobei mindestens eine emittierende Schicht mindestens eine Verbindung gemäß Formel A enthält. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die eine thermisch aktivierte verzögerte Fluoreszenz zeigen. Insbesondere bevorzugt sind Dreischichtsysteme, wobei die drei Schichten blaue, grüne und orange oder rote Emission zeigen (für den prinzipiellen Aufbau siehe z. B. WO 05/011013).

Wenn die Verbindung gemäß Formel A als emittierende Verbindung in einer emittierenden Schicht eingesetzt wird, wird sie bevorzugt in Kombination mit einem oder mehreren Matrixmaterialien eingesetzt. Die Mischung aus der Verbindung gemäß Formel A und dem Matrixmaterial enthält zwischen 1 und 99 Vol.-%, vorzugsweise zwischen 2 und 90 Vol.-%, besonders bevorzugt zwischen 4 und 85 Vol.-%, insbesondere zwischen 5 und 80 Vol.-% der Verbindung gemäß Formel A bezogen auf die Gesamtmischung aus Emitter und Matrixmaterial. Entsprechend enthält die Mischung zwischen 99 und 1 Vol.-%, vorzugsweise zwischen 98 und 10 Vol.-%, besonders bevorzugt zwischen 96 und 15 Vol.-%, insbesondere zwischen 95 und 20 Vol.-% des Matrixmaterials bezogen auf die Gesamtmischung aus Emitter und Matrixmaterial.

Da die Verbindungen gemäß Formel A im Allgemeinen hohe Glasübergangstemperaturen aufweisen, eignen sie sich weiterhin auch zum Einsatz als Reinschicht ohne die Verwendung eines Matrixmaterials. Somit enthält die emittierende Schicht in einer bevorzugten Ausführungsform ausschließlich die Verbindung gemäß Formel A, d.h. in einer Konzentration von 100 %, und somit keinerlei weiteres Matrixmaterial.

Geeignete Matrixmaterialien sind Ketone, Phosphinoxide, Sulfoxide und Sulfone, z. B. gemäß WO 04/013080, WO 04/093207, WO 06/005627 oder der nicht offen gelegten Anmeldung DE 102008033943.1, Triarylamine, Carbazolderivate, z. B. CBP (N,N-Biscarbazolylbiphenyl) oder die in WO 05/039246, US 2005/0069729, JP 2004/288381, EP 1205527 oder WO 08/086851 offenbarten Carbazolderivate, Indolocarbazolderivate, z. B. gemäss WO 07/063754 oder WO 08/056746, Azacarbazole, z. B. gemäss EP 1617710, EP 1617711, EP 1731584, JP 2005/347160, bipolare Matrixmaterialien, z. B. gemäss WO 07/137725, Silane, z. B. gemäss WO 05/111172, Azaborole oder Boronester, z. B. gemäss WO 06/117052, Triazinderivate, z. B. gemäss der nicht offen gelegten Anmeldung DE 102008036982.9, WO 07/063754 oder WO 08/056746, oder Zinkkomplexe, z. B. gemäss EP 652273 oder gemäss der nicht offen gelegten Anmeldung DE 102007053771.0.
Es kann auch bevorzugt sein, eine Mischung aus mehreren Matrixmaterialien als gemischte Matrix für die Verbindung gemäß Formel A zu verwenden. Besonders bevorzugt hat eine Komponente der Matrix dann elektronenleitende Eigenschaften, ist also beispielsweise ein aromatisches Keton oder ein Triazinderivat, und die andere Komponente der Matrix hat lochleitende Eigenschaften, ist also beispielsweise ein Carbazolderivat oder ein Arylamin.

In einer weiteren bevorzugten Ausführungsform der Erfindung wird die Verbindung der Formel A als Co-Host für eine weitere lumineszierende Verbindung, die bei längerer Wellenlänge emittiert, verwendet. Dabei können als lumineszierende Verbindung, welche bei längerer Wellenlänge emittiert, generell alle lumineszierenden Materialien, wie sie gemäss dem Stand der Technik bekannt sind, verwendet werden. So kann eine Verbindung der Formel A, welche im blauen Bereich emittiert, als Co-Host für eine grün lumineszierende Verbindung eingesetzt werden und eine Verbindung, welche im grünen Bereich emittiert, als Co-Host für eine rot lumineszierende Verbindung.. Als weiterer Co-Host wird besonders bevorzugt ein elektronenleitendes Matrixmaterial eingesetzt. Ein solcher Device-Aufbau ist beispielsweise allgemein in der Anmeldung DE 102008063470.0 offenbart.

Weiterhin bevorzugt ist eine organische Elektrolumineszenzvorrichtung, bei der eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Es ist auch möglich, dass der Anfangsdruck noch geringer ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Die erfindungsgemäßen organischen Elektrolumineszenzvorrichtungen zeichnen sich durch folgende überraschende Vorteile gegenüber dem Stand der Technik aus:
1. Die Verbindungen gemäß Formel A weisen sowohl eine hohe thermische Stabilität auf und sind neutral, eignen sich also gut für die Verarbeitung aus der Gasphase.
2. Organische Elektrolumineszenzvorrichtungen enthaltend Verbindungen gemäß Formel A) als emittierende Materialien weisen eine exzellente Lebensdauer auf.
3. Es sind blau lumineszierende Komplexe zugänglich, welche eine tiefblaue Emissionsfarbe und bei Verwendung in organischen Elektrolumineszenzvorrichtungen eine hohe Lebensdauer aufweisen. Dies ist ein Fortschritt gegenüber dem Stand der Technik, da bislang bei blau phosphoreszierenden Vorrichtungen noch Verbesserungsbedarf hinsichtlich der Farbkoordinaten und insbesondere der Lebensdauer gab.
4. Die erfindungsgemässen organischen Elektrolumineszenzvorrichtungen zeigen hohe Effizienzen und steile Strom-Spannungs-Kurven.

Diese oben genannten Vorteile gehen nicht mit einer Verschlechterung der weiteren elektronischen Eigenschaften einher. Die Erfindung wird durch die nachfolgenden Beispiele näher erläutert, ohne sie dadurch einschränken zu wollen. Der Fachmann kann, ohne erfinderisch tätig zu werden, die Erfindung im gesamten offenbarten Bereich ausführen und so weitere erfindungsgemässe organische Elektrolumineszenzvorrichtungen bzw. erfindungsgemässe Komplexe herstellen.

### Beispiele

In den hier gezeigten Beispielen ist der zweizähnige E∩D-Ligand der allgemeinen Formel A ein Amin-Phosphinligand (mit E = PPh₂ und D = NMe₂ bzw. E = PPh₂ und D = N(CH₂)₄), ein Amin-Thioetherligand (mit E = SPh und D = NMe₂), ein Phosphin-Carbenligand (mit E = PPh₂ und D = C*), ein Amin-Carbenligand (mit E = NMe₂ und D = C*) oder ein Thioether-Carbenligand (mit E = SPh und D = C*).
Die gestrichelt gezeichnete Doppelbindung im Carbenliganden bedeutet, dass entweder nur eine Einfachbindung vorliegt und somit ein Imidazolidin-Carben verwendet wird, oder dass alternativ eine Doppelbindung vorliegt und somit ein Imidazol-Carben eingesetzt wird.

### Beispiele für Komplexe der Form M₂X₂(E∩D)₂

### I. E∩D - Ph₂PMe₂NBenzyl, X = Cl, Br, I: Cu₂Cl₂(Ph₂PMe₂NBenzyl)₂ (1a), Cu₂Br₂(Ph₂PMe₂NBenzyl)₂(1b), Cu₂I₂(Ph₂PMe₂NBenzyl)₂(1c)

Bei den Verbindungen **1a-c** handelt es sich um gelbe, feinkristalline Feststoffe.

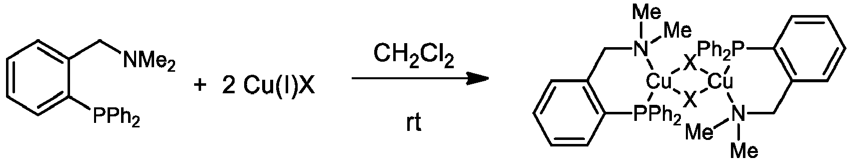

Charakterisierung:
**1a:** ¹H-NMR (CDCl₃): δ 7.75 - 7.02 (m, Ar-H, 28 H), 3.41(bs, CH₂, 4 H), 2.33 (bs,
   NMe₂,12 H)ppm.
   ³¹P-NMR (CDCl₃): -21 ppm.
   EA C₄₂H₄₄Cu₂Cl₂N₂P₂ (834.09): ber.: C 60.29; H 5.30, N 3.35
   gef.:C60.10;H5.51,N3.12
**1b:** ¹H-NMR (CDCl₃): δ 7.66 - 7.20 (m, Ar-H, 28 H), 3.47 (bs, CH₂, 4 H), 2.42 (bs,
   NMe₂, 12 H) ppm.
   ³¹P-NMR (CDCl₃): -20 ppm.
   IR (ATR): 3045 (vw), 2998 (vw), 2825 (vw), 1585 (vw), 1461 (w), 1434 (w), 1370 (w),
   1309 (vw), 1242 (vw), 1173 (vw), 1128 (vw), 1096 (s), 1035 (w), 1000 (s), 880 (vw), 836 (s), 752 (vs), 744 (vs), 694 (vs), 621 (w), 518 (vs), 489 (vs), 451 (m), 436 (s) cm⁻¹
   FAB-MS 926 [M]⁺, 845 [Cu₂BrL₂]⁺, 526 [Cu₂BrL]⁺, 463 [CuBrL]⁺, 383
[CuL]⁺.
   EA C₄₂H₄₄Cu₂Br₂N₂P₂ (921.99): ber.: C 54.50; H 4.79; N 3.03
   gef.: C 54.30; H 4.85; N 2.82
**1c:** ¹H-NMR (CDCl₃): δ 7.72 - 7.10 (m, Ar-H, 28 H), 3.45(bs, CH₂, 4 H), 2.40 (bs, NMe₂,
   12 H) ppm.
   ³¹P-NMR (CDCl₃): -18 ppm.
   IR (ATR): 2823 (vw), 1568 (vw), 1476 (w), 1454 (w), 1432 (m), 1359 (vw), 1305 (vw),
   1203 (vw), 1162 (vw), 1125 (vw), 1093 (m), 997 (m), 984 (m), 886 (w), 836 (s), 761
   (vw), 744 (vs), 692 (vs), 619 (vw), 530 (m), 509 (vs), 490 (vs), 454 (vs), 426 (vs) cm⁻¹
   FAB-MS 1022 [Cu₂l₂L₂]⁺, 892 [Cu₂lL]⁺, 505 [CulL]⁺.
   EA C₄₂H₄₄Cu₂l₂N₂P₂ (1017.97): ber.: C 49.47; H 4.35; N, 2.75
   gef.: C 49.36; H 4.40; N 2.53

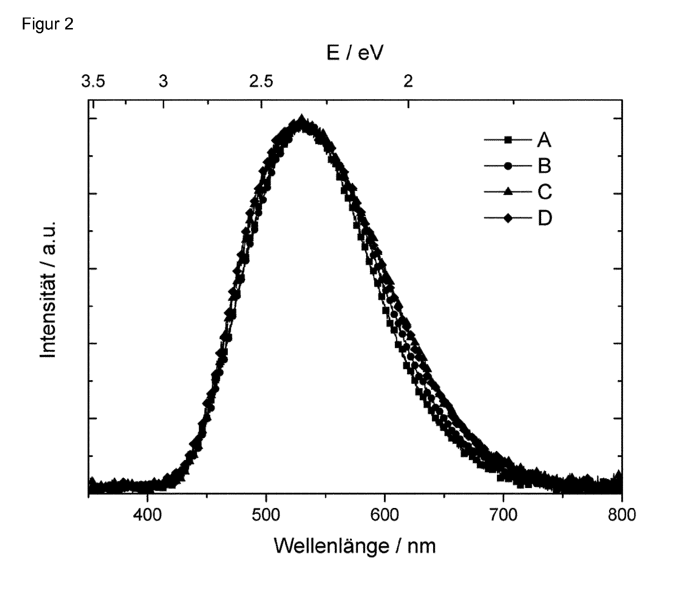

Die Kristallstruktur ist in Fig. 2 (**1b**) dargestellt.

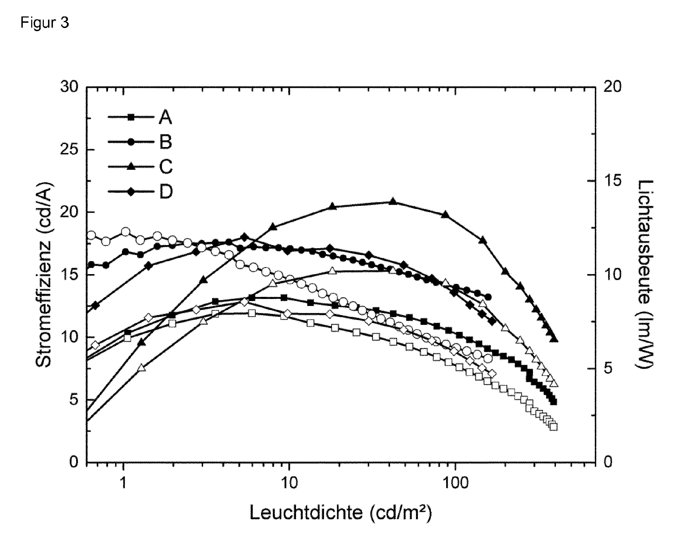

Die Emissionsspektren von **1a** - 1c sind in Fig. 3 gezeigt.

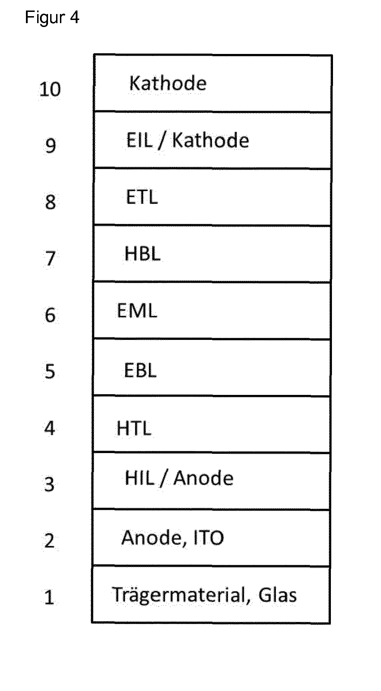

Die berechneten Grenzorbitale des Grundzustands von **1b** sind in Fig. 4 gezeigt.

### II. E∩D = Ph₂PMe₂NNaphtyl, X = Cl, Br, I, CN: Cu₂Cl₂(Ph₂PMe₂NNaphtyl)₂ (2a), Cu₂Br₂(Ph₂PMe₂NBenzyl)₂ (2b), Cu₂l₂(Ph₂PMe₂NBenzyl)₂ (2c), Cu₂CN₂(Ph₂PMe₂NBenzyl)₂ (2d),

Bei den Verbindungen **2a-d** handelt es sich um weiße, feinkristalline Feststoffe.

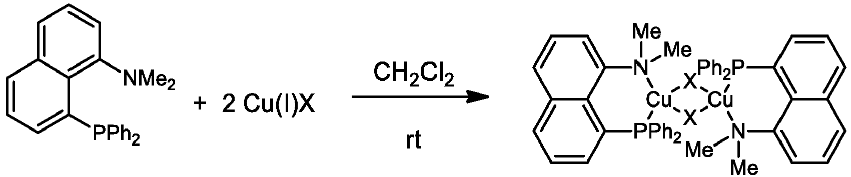

Charakterisierung:
Elementaranalyse:
   **2a:** Summenformel: C₄₈H₄₄Cl₂Cu₂N₂P₂ · ½ H₂O
      ber.: C 62.20; H 5.00; N 3.02
      gef.: C 62.02; H 4.71; N 2.87
   **2b:** Summenformel: C₄₈H₄₄Br₂Cu₂N₂P₂
      ber.: C 57.78; H 4.45; N 2.81
      gef.: C 57.61; H 4.36; N 2.64
   **2c:** Summenformel: C₄₈H₄₄Cl₂Cu₂N₂P₂
      ber.: C 52.81; H 4.06; N 2.57
      gef.: C 52.60; H 3.93; N 2.34
   **2d:** Summenformel: C₅₀H₄₄Cu₂N₄P₂ · ½ H₂O
      ber.: C 66.14; H 5.11; N 6.17
      gef.: C 65.72; H 4.76; N 6.57

Die Emissionsspektren von **2a** - **2d** sind in Fig. 5 gezeigt.

### III. E∩D = Ph₂POMe₂NPhenyl, X = Cl, Br, I: Cu₂Cl₂(Ph₂POMe₂NPhenyl)₂ (3a), Cu₂Br₂(Ph₂POMe₂NPhenyl)₂ (3b), Cu₂I₂(Ph₂POMe₂NPhenyl)₂ (3c)

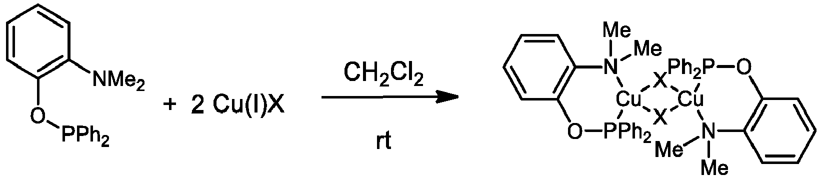

### IV. E∩D = PhSMe₂NBenzyl, X = Cl, Br, I: Cu₂Cl₂(PhSMe₂NBenzyl)₂ (4a), Cu₂Br₂(PhSMe₂NBenzyl)₂ (4b), Cu₂l₂(PhSMe₂NBenzyl)₂ (4c)

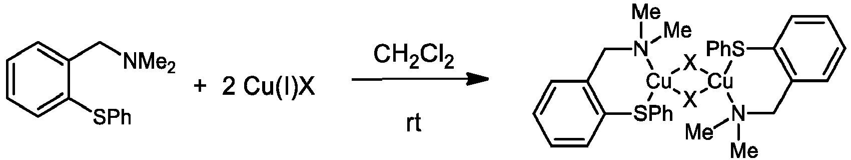

### V. E∩D = Me₂NPhSBenzyl, X = Cl, Br, I: Cu₂Cl₂(Me₂NPhSBenzyl)₂ (5a), Cu₂Br₂(Me₂NPhSBenzyl)₂ (5b), Cu₂l₂(Me₂NPhSBenzyl)₂ (5c)

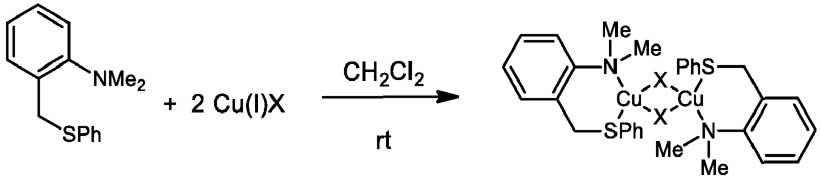

### VI. E∩D = Ph₂PNHCPhenyl, X = Cl, Br, I: Cu₂Cl₂(Ph₂PNHCPhenyl)₂ (6a), Cu₂Br₂(Ph₂PNHCPhenyl)₂ (6b), Cu₂l₂(Ph₂PNHCPhenyl)₂ (6c)

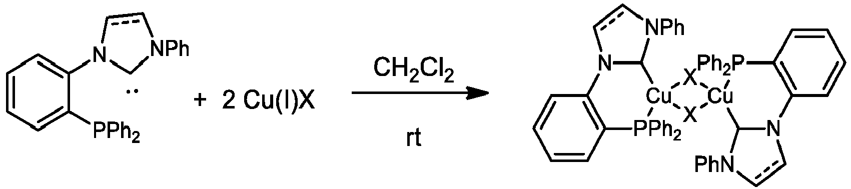

Bevorzugt ist die folgende Reaktion:

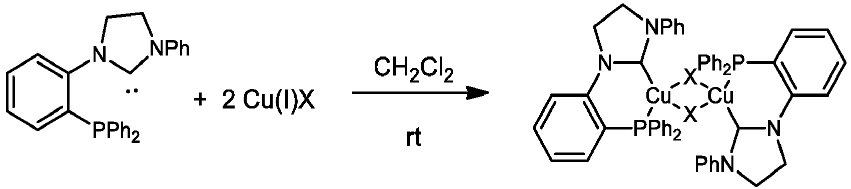

### VII. E∩D = Me₂NNHCPhenyl, X = Cl, Br, I: Cu₂Cl₂(Me₂NNHCPhenyl)₂ (7a), Cu₂Br₂(Me₂NNHCPhenyl)₂ (7b), Cu₂l₂(Me₂NNHCPhenyl)₂ (7c)

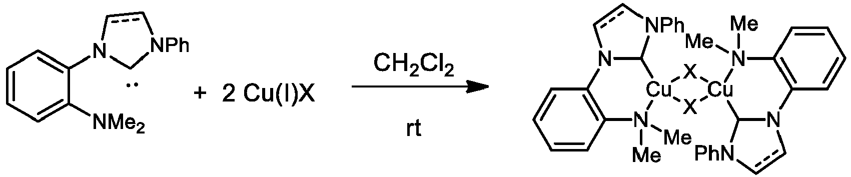

Bevorzugt ist die folgende Reaktion:

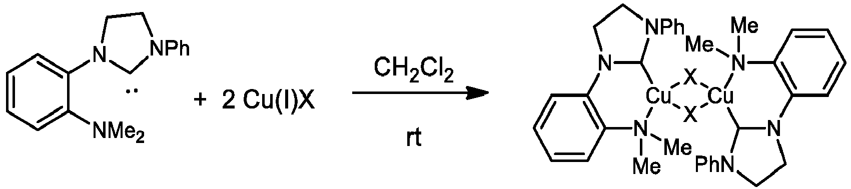

### VIII. E∩D = PhSNHCPhenyl, X = Cl, Br, I: Cu₂Cl₂(PhSNHCPhenyl)₂ (8a), Cu₂Br₂(PhSNHCPhenyl)₂ (8b), Cu₂l₂(PhSNHCPhenyl)₂ (8c)

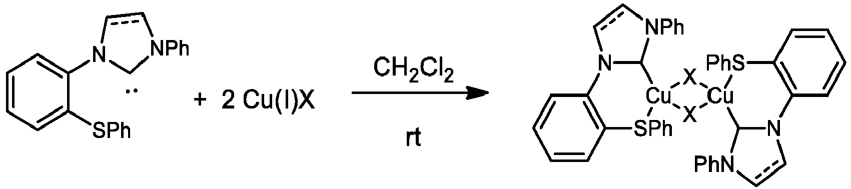

Bevorzugt ist die folgende Reaktion:

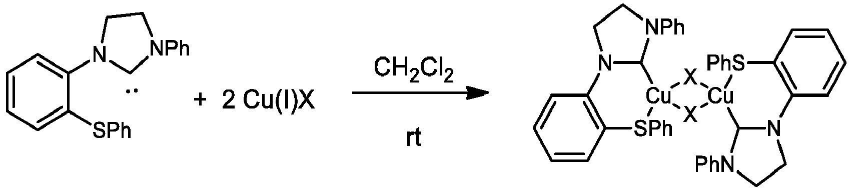

### IX. E∩D = Ph₂P(CH₂)₄NBenzyl, X = Cl, Br, I: C_{U2}Cl₂(Ph₂P(CH₂)₄NBenzyl)₂ (9a), Cu₂Br₂(Ph₂P(CH₂)₄NBenzyl)₂ (9b), Cu₂l₂(Ph₂P(CH₂)₄NBenzyl)₂ (9c)

Bei den Verbindungen **9a-c** handelt es sich um feinkristalline Feststoffe.

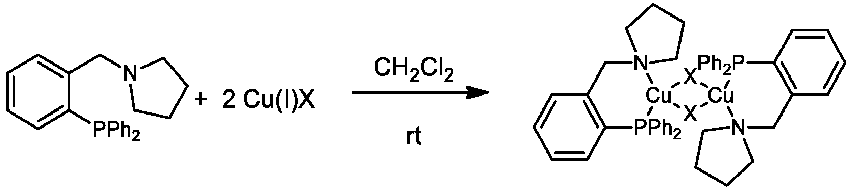

Die vorliegenden Verbindungen wurden mittels 1H und 31P NMR Spektroskopie charakterisiert und ihre Struktur durch Vergleich mit den durch Röntgenbeugung bestätigten, verwandten Strukturen **1a-c** bestimmt.
- **9a:**: ¹H-NMR (CDCl₃): 1.65 (bs, 4H, NCH₂CH₂), 2.45 (bs, 4H, NCH₂CH₂), 3.40 (bs, 2H, ArCH2), 7.00 - 8.00 (m, 14H, Ar-H) ppm.
³¹P-NMR (CDCl₃): -22 ppm.
- **9b:**: ¹H-NMR (CDCl₃): 1.72 (bs, 4H, NCH₂CH₂), 2.53 (bs, 4H, NCH₂CH₂), 3.50 (bs, 2H, ArCH2), 7.00 - 8.00 (m, 14H, Ar-H) ppm.
³¹P-NMR (CDCl₃): -20 ppm.
- **9c:**: ¹H-NMR (CDCl₃): 1.70 (bs, 4H, NCH₂CH₂), 2.52 (bs, 4H, NCH₂CH₂), 3.46 (bs, 2H, ArCH2), 7.00 - 8.00 (m, 14H, Ar-H) ppm.
³¹P-NMR (CDCl₃): -16 ppm.

Die Emissionsspektren von **9a** - **9c** sind in Fig. 6 gezeigt. Die Emissionsspektren von **9c** im Vergleich als Pulver und als Film (pur in Toluol) sind in Fig. 7 gezeigt.

Das Elektrolumineszenzspektrum von **9a** ist in Fig. 8 gezeigt.

Die Strom-Spannungs-Charakteristik sowie die Helligkeit von **9a** ist in Fig. 9 gezeigt.

### X. E∩D = Ph₂P(CH₂)₄NCH₃Benzyl, X = Cl, Br, I: Cu₂Cl₂(Ph₂P(CH₂)₄NCH₃Benzyl)₂ (10a), Cu₂Br₂(Ph₂P(CH₂)₄NCH₃Benzyl)₂ (10b), Cu₂I₂(Ph₂P(CH₂)₄NCH₃Benzyl)₂ (10c)

Bei den Verbindungen **10a-c** handelt es sich um feinkristalline Feststoffe.

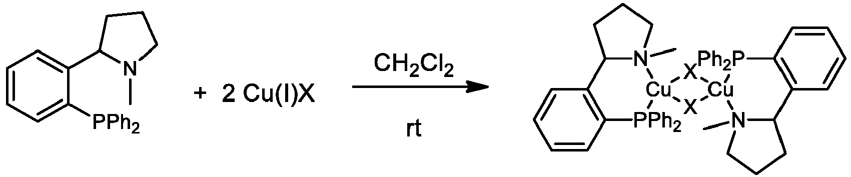

Die vorliegende Verbindung mit X = I wurde mittels 1 H und 31 P NMR Spektroskopie charakterisiert und ihre Struktur durch Vergleich mit den durch Röntgenbeugung bestätigten, verwandten Strukturen 1 a-c bestimmt.
**10c:** ¹H-NMR (CDCl₃): δ = 7.55-7.52 (m, 2H), 7.45-7.28 (m, 11 H), 7.11-7.08 (t, 1 H), 3.78 (s, 1 H), 3.53 (s, 1 H), 2.43 (s,34H), 2.40 (s, 1 H), 2.05 (m, 1 H), 1.85 (m, 1 H), 1.69 (m, 2H) ppm.
   ³¹P-NMR (CDCl₃): -18 ppm.

Das Emissionsspektrum von **10c** ist in Fig. 10 gezeigt.

### XI. E∩D = Ph₂PPiperidinNBenzyl, X = Cl, Br, I: Cu₂Cl₂(Ph₂PPiperidinNBenzyl)₂ (11a), Cu₂Br₂(Ph₂PPiperidinNBenzyl)₂(11b), Cu₂l₂(Ph₂PPiperidinNBenzyl)₂(11c)

Bei den Verbindungen **11a-c** handelt es sich um feinkristalline Feststoffe.

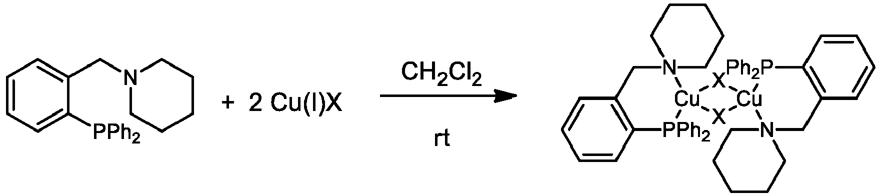

Die vorliegenden Verbindungen mit X = Cl und X = Br wurden mittels 1 H und 31 P NMR Spektroskopie charakterisiert und ihre Struktur durch Vergleich mit den durch Röntgenbeugung bestätigten, verwandten Strukturen 1a-c bestimmt.
**11a:** ¹H-NMR (CDCl₃, 500 MHz) δ = 7.56-7.50 (m, 4H), 7.44-7.33 (m, 6H), 7.32-7.30 (m, 2H), 7.21 (d, 1 H), 6.85 (d, 1 H), 3.56 (s, 2H), 2.58 (s, 4H), 1.95 (s, 4H), 1.34 (s, 2H) ppm.
   ³¹P-NMR (CDCl₃): -19 ppm.
**11b:** ¹H-NMR (CDCl₃, 500 MHz) δ = 7.57-7.54 (m, 4H), 7.44-7.36 (m, 7H), 7.30-7.25 (m, 2H), 6.98-6-92 (m, 1 H), 3.57 (s, 2H), 2.60 (s, 4H), 2.00 (s, 4H), 1.44 (s, 2H) ppm.
   ³¹P-NMR (CDCl₃): -20 ppm.
**11c:** EA: ber.: C 50.06; H 4.38; N, 2.54
   gef.: C 49.92; H 4.23; N 2.50

Die Emissionsspektren von **11a**-**11c** sind in Fig. 11 gezeigt.

### XII. E∩D = Ph₂PPiperidinN-meta-Fluor-Benzyl, X = Cl, Br, I: Cu₂Cl₂(Ph₂PPiperidinN-meta-Fluor-Benzyl)₂ (12a), Cu₂Br₂(Ph₂PPiperidinN-meta-Fluor-Benzyl)₂ (12b), Cu₂l₂(Ph₂PPiperidinN-meta-Fluor-Benzyl)₂ (12c)

Bei den Verbindungen **12a-c** handelt es sich um feinkristalline Feststoffe.

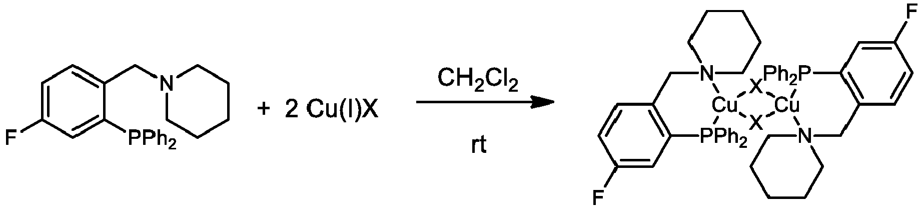

Die vorliegende Verbindung mit X = I wurde mittels 1 H und 31 P NMR Spektroskopie charakterisiert und ihre Struktur durch Vergleich mit den durch Röntgenbeugung bestätigten, verwandten Strukturen 1 a-c bestimmt.
**12c:** ¹H-NMR (CDCl₃, 500 MHz) δ = 7.54 (td, 4H), 7.40-7.37 (m, 2H), 7.33-7.30 (m, 4H), 7.25-7.21 (m, 1 H), 7.01 (td, 1 H), 6.59 (td, 1 H), 3.54 (s, 2H), 2.57 (s, 4H), 1.91 (s, 4H), 1.38 (s, 2H) ppm.
   ³¹P-NMR (CDCl₃): -24 ppm.

Das Emissionsspektrum von **12c** ist in Fig. 12 gezeigt.

### XIII. E∩D = Ph₂PPiperidinN-meta-Dimethylamino-Benzyl, X = Cl, Br, I: Cu₂Cl₂(Ph₂PPiperidinN-meta-Dimethylamino-Benzyl)₂ (13a), Cu₂Br₂(Ph₂PPiperidinN-meta-Dimethylamino-Benzyl)₂ (13b), Cu₂l₂(Ph₂PPiperidinN-meta-Dimethylamino-Benzyl)₂(13c)

Bei den Verbindungen **13a-c** handelt es sich um feinkristalline Feststoffe.

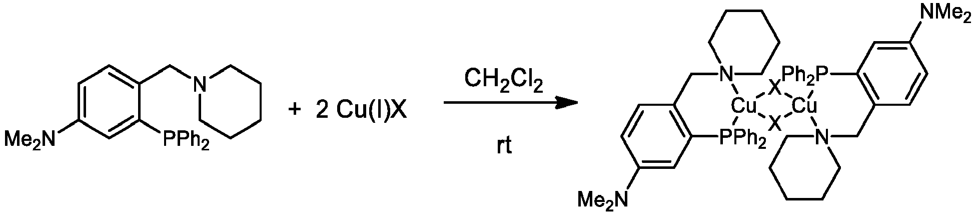

Die vorliegende Verbindung mit X = I wurde mittels 1 H und 31 P NMR Spektroskopie charakterisiert und ihre Struktur durch Vergleich mit den durch Röntgenbeugung bestätigten, verwandten Strukturen 1 a-c bestimmt.
**13c:** ¹H-NMR (CDCl₃, 500 MHz) δ = 7.58-7.52 (m, 4H), 7.41-7.33 (m, 6H), 7.07 (dd, 1 H), 6.62 (dd, 1 H), 6.16 (dd, 1 H), 3.48 (s, 2H), 2.72 (s, 6H), 2.58 (s, 4H), 2.00 (s, 4H), 1.49 (s, 2H) ppm.
   ³¹P-NMR (CDCl₃): -19 ppm.

Das Emissionsspektrum von **13c** ist in Fig. 13 gezeigt.

### XIV. E∩D = Ph₂PMorpholinNBenzyl, X = Cl, Br, I: Cu₂Cl₂(Ph₂PMorpholinNBenzyl)₂ (14a), Cu₂Br₂(Ph₂P-2,6-dimethylmorpholinNBenzyl)₂ (14b), Cu₂l₂(Ph₂PMorpholinNBenzyl)₂ (14c)

Bei den Verbindungen **14a-c** handelt es sich um feinkristalline Feststoffe.

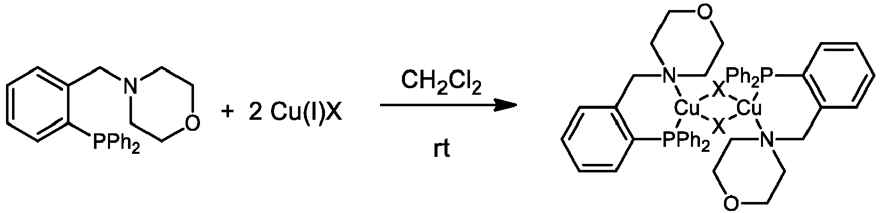

Die vorliegenden Verbindungen wurden mittels 1H und 31P NMR Spektroskopie charakterisiert und ihre Struktur durch Vergleich mit den durch Röntgenbeugung bestätigten, verwandten Strukturen 1 a-c bestimmt.
**14a:** EA: ber.: C 60.00; H 5.25; N 3.04,
   gef.: C 59.55; H 5.10; N 3.08
**14b:** EA: ber.: C 54.72; H 4.79, N 2.77,
   gef.: C 54.47.55; H 4.70; N 2.89

Die Emissionsspektren von **14a -14c** sind in Fig. 14 gezeigt.

### XV. E∩D = Ph₂P-2,6-dimethylmorpholinNBenzyl, X = Cl, Br, I: Cu₂Cl₂(Ph₂P-2,6-dimethylmorpholinNBenzyl)₂ (15a), Cu₂Br₂(Ph₂P-2,6-dimethylmorpholinNBenzyl)₂ (15b), Cu₂l₂(Ph₂P-2,6-dimethylmorpholinNBenzyl)₂ (15c)

Bei den Verbindungen **15a-c** handelt es sich um feinkristalline Feststoffe.

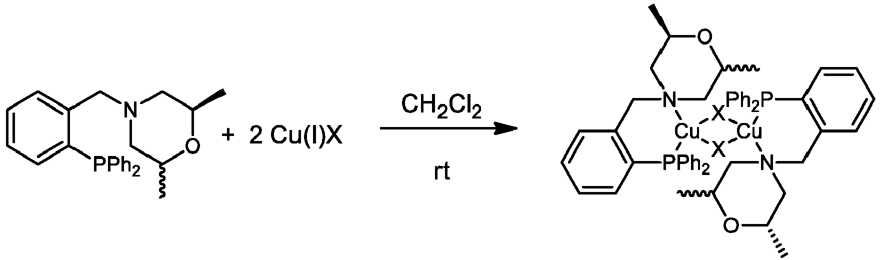

Die vorliegende Verbindung mit X = I wurde mittels 1 H und 31 P NMR Spektroskopie charakterisiert und ihre Struktur durch Vergleich mit den durch Röntgenbeugung bestätigten, verwandten Strukturen 1 a-c bestimmt.
**15c:** ¹H-NMR (CDCl₃, 500 MHz) δ = 7.56-7.53 (m, 4H), 7.39-7.35 (m, 3H), 7.31-7.27 (m, 6H), 6.90 (td, 1 H), 4.49 (m, 2H), 3.60 (s, 2H), 3.07 (d, 2H), 1.77-1.73 (m, 2H), 1.02 (s, 3H), 1.01 (s, 3H) ppm.
   ³¹P-NMR (CDCl₃): -24 ppm.

Das Emissionsspektrum von **15c** ist in Fig. 15 gezeigt.

### XVI. E∩D = Me₂C₄H₆PPhenylenOPhosphinoxid, X = Cl, Br, I: Cu₂Cl₂(Me₂C₄H₆PPhenylen-OPhosphinoxid)₂ (16a), Cu₂Br₂(Me₂C₄H₆PPhenylenOPhosphinoxid)₂ (16b), Cu₂l₂(Me₂C₄H₆-PPhenylenOPhosphinoxid)₂ (16c)

Bei den Verbindungen **16a-c** handelt es sich um feinkristalline Feststoffe.

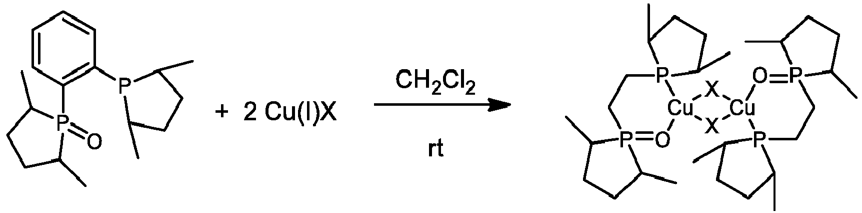

Die vorliegenden Verbindungen mit X = Br und X = I wurden mittels 1H und 31P NMR Spektroskopie; sowie Massenspektroskopie charakterisiert und ihre Struktur durch Vergleich mit den durch Röntgenbeugung bestätigten, verwandten Strukturen 1 a-c bestimmt.
**16b:** ¹H-NMR (CDCl₃, 500 MHz) δ 7.62 (ddd, *J* = 31.4, 23.9, 7.2 Hz, 6H), 2.92 - 2.68 (m, 5H), 2.51 - 2.21 (m, 9H), 1.98 - 1.79 (m, 3H), 1.74 (s, 2H), 1.67 (d, *J* = 11.7 Hz, 1 H), 1.55 - 1.25 (m, 16H), 0.94 (dtd, *J* = 37.5, 15.4, 13.4, 7.0 Hz, 11H).
   ³¹P-NMR (CDCl₃, 202 MHz): δ 73.46, 19.83.
   FAB-MS 932 [M]+, 851 [Cu2BrL2]+, 707 [CuL2]+, 466 [CuBrL]+, 385 [CuL]+.
**16c:** ¹H-NMR (CDCl₃, 500 MHz) δ 7.67 (ddd, *J* = 8.1, 5.3, 2.2 Hz, 2H), 7.61 -7.48 (m, 4H), 7.41 - 7.32 (m, 2H), 2.86 (qdd, *J* = 16.7, 8.3, 4.9 Hz, 6H), 2.42 - 2.11 (m, 11 H), 1.83 (qdd, *J* = 12.8, 5.3, 3.1 Hz, 2H), 1.75 - 1.62 (m, 2H), 1.55 - 1.24 (m, 16H), 1.02 - 0.83 (m, 12H).
   ³¹P-NMR (CDCl₃, 202 MHz): δ 71.76, 9.22.
   Elementaranalyse gef.: C 41.92, H 5.52
   FAB-MS: 1088 [M]+, 899 [Cu2BrL2]+, 707 [CuL2]+, 577 [Cu2lL]+, 512 [CulL]+, 385 [CuL]+.

### XVII bis XVIII: Herstellung und Charakterisierung von organischen Elektrolumineszenzvorrichtungen aus der Gasphase

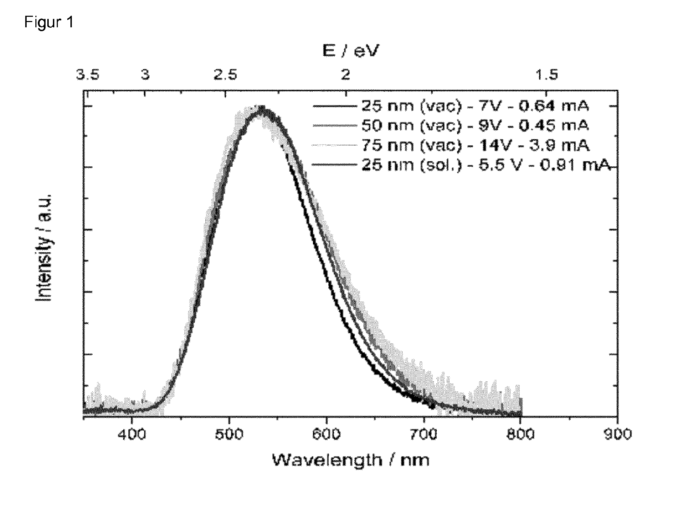

Weitere Ausführungsformen zeigen die Figuren 1 bis 4, in denen OLED-Devices mit den erfindungsgemäßen Emittersubstanzen mittels Vakuum-Sublimationstechnik erstellt werden.

Diese noch nicht optimierten OLEDs werden standardmäßig charakterisiert; hierfür werden die Elektrolumineszenzspektren aufgenommen und die externe Quanteneffizienz (gemessen in %) in Abhängigkeit von der Helligkeit, berechnet aus dem von der Fotodiode detektiertem Licht, den Elektrolumineszenzspektren und dem Strom bestimmt.

Die Bedeutung der in Figur 4 gezeigten Schichten ist wie folgt:
1. Als Trägermaterial kann Glas oder jedes andere geeignete feste oder flexible durchsichtige Material verwendet werden.
2. ITO = Indium-Zinn-Oxid
3. HIL = hole injection layer = Lochinjektionschicht. Hierfür kann beispielsweise das kommerziell erhältliche PEDOT:PSS verwendet werden. Typische Schichtdicke: 20 - 100 nm. Kleine Moleküle können auch verwendet werden (z. B. Kupfer-Phthalocyanin (CuPc z. B. 10 nm dick)) oder Metalloxide z.B. MoO₃, V₂O₅, etc.
   HIL kann auch als Anode angesehen werden.
4. HTL = hole transport layer = Lochtransportschicht. Diese Schicht ist wie hinten ausgeführt, optional, kann jedoch zur Verbesserung der Bauteileigenschaften verwendet werden. Hierfür kann z. B. [alpha]-NPD (N,N'-Di(1-naphthyl)-N,N'-diphenyl-(1,1'-biphenyl)-4,4'-diamin), TAPC (4,4'-Cyclohexyliden-bis[N,N-bis(4-methylphenyl)benzenamine]), TCTA (Tris(4-carbazoyl-9-ylphenyl)amin), mCP (1,3-Bis(N-carbazolyl)benzen) oder TrisPCz (9,9'-Diphenyl-6-(9-phenyl-9H-carbazol-3-yl)-9H,9'H-3,3'-bicarbazol) in einer Dicke von z. B. 20 nm eingesetzt werden.
5. EBL = Die Elektronenblockierschicht (optional) soll dafür sorgen, dass der Elektronentransport zur Anode unterbunden wird, da die Ladungsträger in der Emitter-Schicht gehalten werden und die Lochtransportschicht nicht durch Elektronen degradiert wird (Dicke z. B. 30 nm). Schichte 4 und 5 können ein einziges Material sein wenn die HTL gute Eigenschaften sowohl als Lochtransport- als auch als Elektronenblockierschicht aufweist.
6. EML = Die Emitter-Schicht enthält oder besteht aus dem erfindungsgemässen Emittermaterial. Dieses kann für die sublimierbaren erfindungsgemässen Materialien durch Sublimation aufgetragen werden. Die Schichtdicke kann z. B. zwischen 10 nm und 200 nm liegen. Für im Grünen oder im Roten emittierende erfindungsgemässe Emittermaterialien eignen sich die gängigen Matrixmaterialien wie CBP (4,4'-Bis-(N-carbazolyl)-biphenyl). Für im Blauen emittierende erfindungsgemässe Emitter-materialien können UGH-Matrixmaterialien (siehe z. B. M.E. Thompson et al., Chem. Mater. 2004, 16, 4743) oder andere sogenannten Wide-Gap-Matrixmaterialien eingesetzt werden.
7. HBL= Hole Blocking Layer = Die Lochblockierschicht soll die Ladungsträger in der Emitterschicht halten (optional). Diese Schicht kann z. B. 10 nm dick sein. Als Material eignet sich z. B. BCP (4,7-Diphenyl-2,9-dimethylphenanthrolin = Bathocuproin) oder TSPO1 (Diphenyl-4-triphenylsilylphenyl-phosphinoxid).
8. ETL = Electron Transport Layer = Elektronentransportschicht. Zum Beispiel kann das aufdampfbare Alq3 (Aluminium-tris(8-hydroxychinolin)) oder TPBi (1,3,5-Tris(1-phenyl-1H-benzimidazol-2-yl)benzen) verwendet werden. Dicke ist z. B. 25 nm. Schichte 7 und 8 können ein einziges Material sein wenn die ETL gute Eigenschaften sowohl als Elektronentransport- als auch als Lochblockierschicht aufweist.
9. Kathode. Diese Schicht wird in der Regel aufgedampft und ist z.B. LiF, Ca, Mg, Ba. Gegebenenfalls können die ETL- und die CsF-Schicht entfallen. Die Schichtdicke beträgt zwischen 0.5 nm und 30 nm.
10.Al oder anderen stabile Metalle (Cu, Ag,...) werden aufgedampft um die reaktive Kathode zu schützen. Al kann auch mit der unteren Schicht reagieren (z.b LiF/Al) (Xie, Z. T., Zhang, W. H., Ding, B. F., Gao, X. D., You, Y. T., Sun, Z. Y., ... Hou, X. Y. (2009). Interfacial reactions at Al/LiF and LiF/Al. Applied Physics Letters, 94(6), 063302. doi:10.1063/1.3077167). Typische Schichtdicken betragen 100 nm.

Die am Device anliegende Spannung beträgt z. B. 2.5 V bis 15 V.

### XVII: Prototypen von aufgedampften Metall(I)komplexen und Variation der Dicke der Emissionsschicht

Verwendet wurde der oben genannte Emitter **1a.**

**Tabelle 1: Device-Ergebnisse bei Variation der Dicke der Emissionsschicht und Schichtaufbau. Dicke TSPO1: 25 nm, TPBi: 25 nm.**

| OLEDs | | | | | | | | Bemerkungen | Effizienz | CIE |
|---|---|---|---|---|---|---|---|---|---|---|
| | ITO | PEDOT:PSS | Emitter 1a (50nm) | TSPO1 | TPBi | LiF | Al | λmax= 535 nm | 58 cd/m², 11.3 cd/A, 4 lm/W, 3.8% EQE | (0.35, 0.49) |
| | | | (subl.) | | | | | | Best device: 47 cd/m², 21.1 cd/A, 7.7 lm/W, 7% EQE, Von 5 V | |
| | ITO | PEDOT:PSS | Emitter 1a (25nm) | TSPO1 | TPBi | LiF | Al | λmax= 530 nm | 564 cd/m², 13.7 cd/A, 7.3 lm/W, 4.7% EQE | (0.32, 0.49) |
| | | | (subl.) | | | | | | Best device: 783 cd/m², 15.9cd/A, 8.4 lm/W, 5.1% EQE, Von 5 V | |
| | ITO | PEDOT:PSS | Emitter 1a (50nm) | TSPO1 | TPBi | LiF | Al | λmax= 530 nm | 352 cd/m², 11.4 cd/A, 4.6 lm/W,3.5% EQE | (0.34, 0.48) |
| | | | (subl.) | | | | | | Best device: 810 cd/m², 14.2 cd/A, 5.2 lm/W, 4.4 % EQE, Von 6.5 V | |
| | ITO | PEDOT:PSS | Emitter 1a (75nm) | TSPO1 | TPBi | LiF | Al | λmax= 530 nm | 110 cd/m², 6 cd/A, 2 lm/W,2.3% EQE | (0.34, 0.48) |
| | | | (subl.) | | | | | | Best device: 110 cd/m², 8.4 cd/A, 2 Im/W, 3.2 % EQE, Von 10 V | |

Die Elektrolumineszenzspektren der oben gezeigten Bauteile sind in Figur 1 gezeigt (Intensität über Wellenlänge).

### XVIII: Beispiel: Variation der Lochleitschicht HTL und Einfluss auf die Bauteilperformance

Verwendet wurde der oben genannte Emitter **1a.**

**Tabelle 2: Variation der Lochleitschicht. Device-Aufbau: Dicke PEDOT:PSS zwischen 15 bis 35 nm, TAPC zwischen 15 bis 35 nm, EML zwischen 15 bis 45 nm, TSPO1 zwischen 15 bis 35 nm, TPBI zwischen 15 bis 35 nm.**

| OLED Nummer | Schicht 1 | Schicht 2 | Schicht 3 | Schicht 4 | Schicht 5 | Schicht 6 | Schicht 7 | Schicht 8 |
|---|---|---|---|---|---|---|---|---|
| A | ITO | PEDOT:PSS | ∅ | Emitter 1a | TSPO1 | TPBi | LiF | Al |
| B | ITO | PEDOT:PSS | TAPC | Emitter 1a | TSPO1 | TPBi | LiF | Al |
| C | ITO | PEDOT:PSS | TCTA | Emitter 1a | TSP01 | TPBi | LiF | Al |
| D | ITO | PEDOT:PSS | TrisPCz | Emitter 1a | TSPO1 | TPBi | LiF | Al |

**Tabelle 3: Device-Ergebnisse der Tabelle 2**

| OLED Nummer | Wellenlänge (nm) | CIE | Leuchtdichte (cd/m²) | Lichtausbeute (lm/W) | Stromeffizienz (cd/A) | EQE (%) |
|---|---|---|---|---|---|---|
| A | 530 | (0.32, 0.49) | 400 | 8 | 13 | 4 |
| B | 530 | (0.33, 0.48) | 160 | 12 | 18 | 6 |
| C | 530 | (0.35, 0.52) | 390 | 12 | 25 | 9 |
| D | 510/515 | (0.30, 0.49) | 170 | 8 | 18 | 7 |

Die Elektrolumineszenzspektren der oben gezeigten Bauteile sind in den Figuren 1 und 2 gezeigt.

Abbildung: Molekulare Struktur der Materialien in der Lochleitschicht:

| | HOMO | LUMO | ET | Struktur |
|---|---|---|---|---|
| TAPC | -5.4 | -1.8 | 3 | 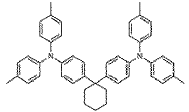 |
| TCTA | -5.6 | -2 | 2.9 | 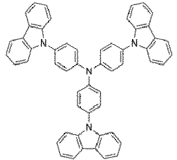 |
| TrisPCz | -5.6 | | | 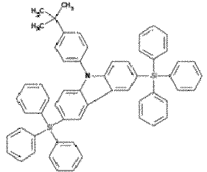 |

Hingewiesen wird auf die folgenden Figuren:
Figuren 1 und 2: Elektrolumineszenzspektren zu den obigen Versuchen,
Figur 3: Effizienzkennlinien zu den obigen Versuchen,
Figur 4: Aufbau eines OLED-Bauteils.

Gemäß zumindest einer Ausführungsform weist ein organisches Licht emittierendes Bauelement auf einem Substrat zumindest zwei Elektroden auf, von denen zumindest eine transluzent ist und zwischen denen ein organischer funktioneller Schichtenstapel angeordnet ist. Der organische funktionelle Schichtenstapel weist zumindest eine organische Licht emittierende Schicht in Form einer organischen elektrolumineszierenden Schicht auf, die im Betrieb des organischen Licht emittierenden Bauelements Licht erzeugt. Das organische Licht emittierende Bauelement kann insbesondere als organische Licht emittierende Diode (OLED) ausgebildet sein.
Mit "transluzent" wird hier und im Folgenden eine Schicht bezeichnet, die durchlässig für sichtbares Licht ist. Dabei kann die transluzente Schicht transparent, also klar durchscheinend, oder zumindest teilweise Licht streuend und/oder teilweise Licht absorbierend sein, so dass die transluzente Schicht beispielsweise auch diffus oder milchig durchscheinend sein kann. Besonders bevorzugt ist eine hier als transluzent bezeichnete Schicht möglichst transparent ausgebildet, so dass insbesondere die Absorption von Licht so gering wie möglich ist.

Der organische funktionelle Schichtstapel kann Schichten mit organischen Polymeren, organischen Oligomeren, organischen Monomeren, organischen kleinen, nicht-polymeren Molekülen ("small molecules") oder Kombinationen daraus aufweisen. Als Materialien für die organische Licht emittierende Schicht eignen sich Materialien, die eine Strahlungsemission aufgrund von Fluoreszenz oder Phosphoreszenz aufweisen, beispielsweise Polyfluoren, Polythiophen oder Polyphenylen oder Derivate, Verbindungen, Mischungen oder Copolymere davon. Der organische funktionelle Schichtenstapel kann auch eine Mehrzahl von organischen Licht emittierenden Schichten aufweisen, die zwischen den Elektroden angeordnet sind. Der organische funktionelle Schichtenstapel kann weiterhin eine funktionelle Schicht aufweist, die als Lochtransportschicht ausgeführt ist, um eine effektive Löcherinjektion in die zumindest eine Licht emittierende Schicht zu ermöglichen. Als Materialien für eine Lochtransportschicht können sich beispielsweise tertiäre Amine, Carbazolderivate, mit Camphersulfonsäure dotiertes Polyanilin oder mit Polystyrolsulfonsäure dotiertes Polyethylendioxythiophen als vorteilhaft erweisen. Der organische funktionelle Schichtenstapel kann weiterhin eine funktionelle Schicht aufweisen, die als Elektronentransportschicht ausgebildet ist. Darüber hinaus kann der Schichtenstapel auch Elektronen- und/oder Löcherblockierschichten aufweisen.

Das Substrat (fester Träger) kann beispielsweise eines oder mehrere Materialien in Form einer Schicht, einer Platte, einer Folie oder einem Laminat aufweisen, die ausgewählt sind aus Glas, Quarz, Kunststoff, Metall, Siliziumwafer. Besonders bevorzugt weist das Substrat Glas, beispielsweise in Form einer Glasschicht, Glasfolie oder Glasplatte, auf oder ist daraus.

Im Hinblick auf den prinzipiellen Aufbau eines organischen Licht emittierenden Bauelements, dabei beispielsweise im Hinblick auf den Aufbau, die Schichtzusammensetzung und die Materialien des organischen funktionellen Schichtenstapels, wird auf die Druckschrift WO 2010/066245 A1 verwiesen, die insbesondere im Bezug auf den Aufbau eines organischen Licht emittierenden Bauelements hiermit ausdrücklich durch Rückbezug aufgenommen wird.

Die zwei Elektroden, zwischen denen der organische funktionelle Schichtenstapel angeordnet ist, können beispielsweise beide transluzent ausgebildet sein, sodass das in der zumindest einen Licht emittierenden Schicht zwischen den beiden Elektroden erzeugte Licht in beide Richtungen, also in Richtung des Substrat als auch in die vom Substrat abgewandte Richtung, abgestrahlt werden können. Weiterhin können beispielsweise alle Schichten des organischen Licht emittierenden Bauelements transluzent ausgebildet sein, sodass das organische Licht emittierende Bauelement eine transluzente und insbesondere eine transparente OLED bildet. Darüber hinaus kann es auch möglich sein, dass eine der beiden Elektroden, zwischen denen der organische funktionelle Schichtenstapel angeordnet ist, nichttransluzent und vorzugsweise reflektierend ausgebildet ist, sodass das in der zumindest einen Licht emittierenden Schicht zwischen den beiden Elektroden erzeugte Licht nur in eine Richtung durch die transluzente Elektrode abgestrahlt werden kann. Ist die auf dem Substrat angeordnete Elektrode transluzent und ist auch das Substrat transluzent ausgebildet, so spricht man auch von einem so genannten "bottom emitter", während man im Fall, dass die dem Substrat abgewandt angeordnete Elektrode transluzent ausgebildet ist, von einem so genannten "top emitter" spricht.

Gemäß einer weiteren Ausführungsform weist die transluzente Elektrode ein transparentes leitendes Oxid auf oder besteht aus einem transparenten leitenden Oxid. Transparente leitende Oxide (TCO: "transparent conductive oxide") sind transparente, leitende Materialien, in der Regel Metalloxide, wie beispielsweise Zinkoxid, Zinnoxid, Cadmiumoxid, Titanoxid, Indiumoxid, Indiumzinnoxid (ITO) oder Aluminiumzinkoxid (AZO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, Mgln₂O₄, GalnO₃, Zn₂ln₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.
Weiterhin kann die transluzente Elektrode eine Metallschicht mit einem Metall oder einer Legierung aufweisen, beispielsweise mit einem oder mehreren der folgenden Materialien: Ag, Pt, Au, Mg, Ag:Mg. Weiterhin sind auch andere Metalle möglich. Besonders bevorzugt werden ein oder mehrere Metalle verwendet, die stabil an Luft sind und/oder die selbstpassivierend, beispielsweise durch Ausbildung einer dünnen schützenden Oxidschicht, sind. Die Metallschicht weist dabei eine derart geringe Dicke auf, dass sie zumindest teilweise durchlässig für das von der zumindest einen organischen Licht emittierenden Schicht im Betrieb erzeugte Licht ist, beispielsweise eine Dicke von kleiner oder gleich 50 nm.
Die transluzente Elektrode kann auch eine Kombination aus zumindest einer oder mehreren TCO-Schichten und zumindest einer transluzenten Metallschicht aufweisen.

Die Elektroden können jeweils grossflächig ausgebildet sein. Dadurch kann eine grossflächige Abstrahlung des in der zumindest einen organischen Licht emittierenden Schicht erzeugten Lichts ermöglicht werden. "Grossflächig" kann dabei bedeuten, dass das organische Licht emittierende Bauelement eine Fläche von grösser oder gleich einigen Quadratmillimetern, bevorzugt grösser oder gleich einem Quadratzentimeter und besonders bevorzugt grösser oder gleich einem Quadratdezimeter aufweist.

Gemäß einer weiteren Ausführungsform weist der organische funktionelle Schichtenstapel unmittelbar angrenzend an beide der zwei Elektroden, zwischen denen der organische funktionelle Schichtenstapel angeordnet ist, jeweils eine ladungserzeugende Schicht auf. In diesem Fall grenzt eine Elektronen leitende Schicht zur als Anode ausgebildeten Elektrode und eine Löcher leitende Schicht zur als Kathode ausgebildeten Elektrode hin an. Der organische funktionelle Schichtenstapel mit den beiden Elektroden bildet in diesem Fall eine so genannte invertierte OLED, bei der die Injektion der entsprechenden Ladungsträgersorte jeweils durch den oben beschriebenen inversen Prozess ersetzt wird.

Gemäß einer weiteren Ausführungsform weist der organische funktionelle Schichtenstapel zwischen den Elektroden zumindest zwei organische Licht emittierende Schichten auf, zwischen denen weiterhin eine weitere ladungserzeugende Schicht angeordnet sein kann. Ein solcher organischer funktioneller Schichtenstapel mit den Elektroden kann auch als so genannte gestapelte OLED bezeichnet werden, bei der mehrere organische OLED-Einheiten durch dazwischen angeordnete ladungserzeugende Schichten vertikal übereinander aufgebracht sind. Durch das Übereinanderstapeln mehrerer organischer Licht emittierender Schichten kann zum einen die Erzeugung von Mischlicht ermöglicht werden. Darüber hinaus können in mehrfach gestapelten OLEDs bei praktisch gleicher Effizienz und identischer Leuchtdichte deutlich längere Lebensdauern gegenüber OLEDs mit nur einer Licht emittierender Schicht erzielt werden, da bei gleichen Stromdichten die mehrfache Leuchtdichte ermöglicht werden kann.

Gemäß einer weiteren Ausführungsform sind über den zwei Elektroden mit dem dazwischen angeordneten organischen funktionellen Schichtenstapel und der zumindest einen ladungserzeugenden Schicht ein weiterer organischer funktioneller Schichtenstapel und darüber eine weitere Elektrode angeordnet. Mit anderen Worten weist das organische Licht emittierende Bauelement zumindest drei Elektroden auf, wobei zwischen jeweils benachbarten Elektroden ein organischer funktioneller Schichtenstapel angeordnet ist. Hierdurch ist die zwischen dem organischen funktionellen Schichtenstapel und dem weiteren organischen funktionellen Schichtenstapel angeordnete Elektrode als so genannte Zwischenelektrode ausgeführt, die beispielsweise zur Steuerung der Emissionsfarbe des organischen Licht emittierenden Bauelements im Falle von unterschiedlichen Licht emittierenden Schichten in den organischen funktionellen Schichtenstapeln direkt angesteuert werden kann. Insbesondere kann der weitere organische funktionelle Schichtenstapel unmittelbar angrenzend an zumindest eine der beiden Elektroden, zwischen denen der weitere organische funktionelle Schichtenstapel angeordnet ist, eine weitere ladungserzeugende Schicht aufweisen.

Gemäß einer weiteren Ausführungsform weist das organische Licht emittierende Bauelement unmittelbar angrenzend an jede Elektrode auf der zu einer organischen Licht emittierenden Schicht zugewandten Seite eine ladungserzeugende Schicht auf. Beispielsweise kann die ladungserzeugende Schicht als Löcher leitende Schicht eine p-dotierte Schicht aufweisen, die einen anorganischen oder organischen Dotierstoff in einer organischen Löcher leitenden Matrix aufweist. Als anorganischer Dotierstoff kommen beispielsweise Übergangsmetalloxide wie etwa Vanadiumoxid, Molybdänoxid oder Wolframoxid in Frage. Als organische Dotierstoffe kommen beispielsweise Tetrafluorotetracyanoquinodimethan (F4-TCNQ) oder Kupfer-Pentafluorobenzoat (Cu(I)pFBz) in Frage. Weiterhin kommen als organische Dotierstoffe beispielsweise Übergangsmetallkomplexe in Frage. Diese können bevorzugt ein Zentralatom, beispielsweise Cu, mit Liganden aufweisen, beispielsweise Acetylacetonat (acac) in Frage. Weiterhin kommen beispielsweise Kupferkomplexe, beispielsweise Kupfer-Carboxylate, in Frage. Derartige und weitere Dotierstoffe sind in den Druckschriften WO 2011/033023 A1 und WO 2011/120709 A1 beschrieben, deren jeweiliger Offenbarungsgehalt hiermit in Bezug auf die dort beschriebenen Dotierstoffe vollumfänglich durch Rückbezug aufgenommen wird. Weiterhin kommen beispielsweise auch Metallkomplexe mit Bismut und/oder Chrom in Frage, wie in den noch nicht veröffentlichten Anmeldungen DE 102012209523.3 und DE 102012209520.9 beschrieben ist, deren jeweiliger Offenbarungsgehalt hiermit in Bezug auf die dort beschriebenen Dotierstoffe vollumfänglich durch Rückbezug aufgenommen wird.

Als Elektronen leitende Schicht kann die ladungserzeugende Schicht beispielsweise eine n-dotierte Schicht mit einem n-Dotierstoff in einer organischen Elektronen leitenden Matrix aufweisen, beispielsweise ein Metall mit niedriger Austrittsarbeit wie beispielsweise Cs, Li, Ca, Na, Ba oder Mg oder Verbindungen daraus, beispielsweise Cs2CO3oder Cs3PO4. Derartige und weitere Dotierstoffe sind beispielsweise in der Druckschrift WO 2011/039323 A2 beschrieben, deren jeweiliger Offenbarungsgehalt hiermit in Bezug auf die dort beschriebenen Dotierstoffe vollumfänglich durch Rückbezug aufgenommen wird.
Weiterhin sind auch organische p- und n-Dotierstoffe von der Novaled GmbH erhältlich unter den Markennamen NDP-2^{®} , NDP-9^{®}, NDN-1^{®}, NDN-26^{®}.

Gemäß einer weiteren Ausführungsform ist auf einer der zumindest einen Licht emittierenden Schicht abgewandten Seite der transluzenten Elektrode eine optische Schicht, insbesondere in Form einer Antireflexionsschicht und/oder einer Streuschicht, aufgebracht. Als Antireflexionsschicht kann beispielsweise ein Material mit einem hohen Brechungsindex von grösser oder gleich 1,6 und bevorzugt von grösser oder gleich 1,8 oder sogar grösser oder gleich 2,0 verwendet werden, beispielsweise Titanoxid, Zinkoxid, Tantaloxid und/oder Hafniumoxid. Als Streuschicht kann beispielsweise ein erstes Material mit einem ersten Brechungsindex verwendet werden, in dem ein zweites partikelförmiges Material mit einem zweiten davon unterschiedlichen Brechungsindex eingebettet ist. Das erste Material kann beispielsweise durch einen Kunststoff gebildet werden, während das zweite partikelförmige Material beispielsweise durch ein Oxid, insbesondere eines oder mehrere der vorgenannten Metalloxide, gebildete wird.

Über den Elektroden und den organischen Schichten kann weiterhin noch eine Verkapselungsanordnung angeordnet sein. Die Verkapselungsanordnung kann beispielsweise in Form eines Glasdeckels oder, bevorzugt, in Form einer Dünnschichtverkapselung ausgeführt sein.
Ein Glasdeckel, beispielsweise in Form eines Glassubstrats, das eine Kavität aufweisen kann, kann mittels einer Klebstoffschicht oder eines Glaslots auf dem Substrat aufgeklebt beziehungsweise mit dem Substrat verschmolzen werden. In die Kavität kann weiterhin ein Feuchtigkeit absorbierender Stoff (Getter), beispielsweise aus Zeolith, eingeklebt werden, um Feuchtigkeit oder Sauerstoff, die durch den Klebstoff eindringen können, zu binden. Weiterhin kann auch ein Klebstoff, der ein Getter-Material enthält, zur Befestigung des Deckels auf dem Substrat verwendet werden.
Unter einer als Dünnschichtverkapselung ausgebildeten Verkapselungsanordnung wird vorliegend eine Vorrichtung verstanden, die dazu geeignet ist, eine Barriere gegenüber atmosphärischen Stoffen, insbesondere gegenüber Feuchtigkeit und Sauerstoff und/oder gegenüber weiteren schädigenden Substanzen wie etwa korrosiven Gasen, beispielsweise Schwefelwasserstoff, zu bilden. Die Verkapselungsanordnung kann hierzu eine oder mehrere Schichten mit jeweils einer Dicke von kleiner oder gleich einigen 100 nm aufweisen.
Insbesondere kann die Dünnschichtverkapselung dünne Schichten aufweisen oder aus diesen bestehen, die beispielsweise mittels eines Atomlagenabscheideverfahrens ("atomic layer deposition", ALD) aufgebracht werden. Geeignete Materialien für die Schichten der Verkapselungsanordnung sind beispielsweise Aluminiumoxid, Zinkoxid, Zirkoniumoxid, Titanoxid, Hafniumoxid, Lanthanoxid, Tantaloxid. Bevorzugt weist die Verkapselungsanordnung eine Schichtenfolge mit einer Mehrzahl der dünnen Schichten auf, die jeweils eine Dicke zwischen einer Atomlage und 10 nm aufweisen, wobei die Grenzen eingeschlossen sind.
Alternativ oder zusätzlich zu mittels ALD hergestellten dünnen Schichten kann die Verkapselungsanordnung zumindest eine oder eine Mehrzahl weiterer Schichten, also insbesondere Barrierenschichten und/oder Passivierungsschichten, aufweisen, die durch thermisches Aufdampfen oder mittels eines plasmagestützten Prozesses, etwa Sputtern oder plasmaunterstützter chemischer Gasphasenabscheidung ("plasma-enhanced chemical vapor deposition", PECVD), abgeschieden wird. Geeignete Materialien dafür können die vorab genannten Materialien sowie Siliziumnitrid, Siliziumoxid, Siliziumoxinitrid, Indiumzinnoxid, Indiumzinkoxid, Aluminium-dotiertes Zinkoxid, Aluminiumoxid sowie Mischungen und Legierungen der genannten Materialien sein. Die eine oder die mehreren weiteren Schichten können beispielsweise jeweils eine Dicke zwischen 1 nm und 5 [micro]m und bevorzugt zwischen 1 nm und 400 nm aufweisen, wobei die Grenzen eingeschlossen sind.
Dünnfilmverkapselungen sind beispielsweise aus den Druckschriften WO 2009/095006 A1 und WO 2010/108894 A1 bekannt, deren jeweiliger Offenbarungsgehalt hiermit diesbezüglich vollumfänglich durch Rückbezug aufgenommen wird.

## Patentansprüche

1. Verwendung eines Metall(I)komplexes aufweisend eine oder bestehend aus einer Struktur gemäß Formel A zur Herstellung einer Organischen Elektrolumineszenzvorrichtung mittels eines Vakuumverdampfungsverfahrens 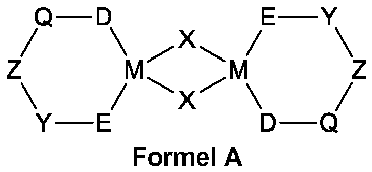 mit
M = unabhängig voneinander ausgewählt aus der Gruppe bestehend aus Cu und Ag;
X = unabhängig voneinander ausgewählt aus der Gruppe bestehend aus Cl, Br, I, CN, OCN, SCN, Alkinyl und N₃;
EnD = unabhängig voneinander ein zweizähniger Ligand mit
E = RR'E* (wenn E* = N, P, As, Sb) oder RE* (wenn E* = C*, O, S) mit E* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
D = RR'D* (wenn D* = N, P, As, Sb) oder RD* (wenn D* = C*, O, S) mit D* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
wobei D und E verschieden voneinander sind;
"∩" = eine dreiteilige Einheit aus Q, Y und Z, die miteinander verbunden sind und unabhängig voneinander ausgewählt sind aus der Gruppe bestehend aus NR, O, S und PR sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind,
wobei optional EnD mindestens einen Substituenten zur Verbesserung des Ladungsträgertransports in Form einen Elektronenleiters oder Lochleiters aufweist,
wobei der Metall(I)komplex zur Bildung einer Emitter- oder Absorberschicht mittels eines Vakuumverdampfungsverfahrens auf einen festen Träger aufgebracht wird.

2. Verwendung nach Anspruch 1, wobei der Metall(I)komplex eine Struktur der Formeln I bis IX aufweist 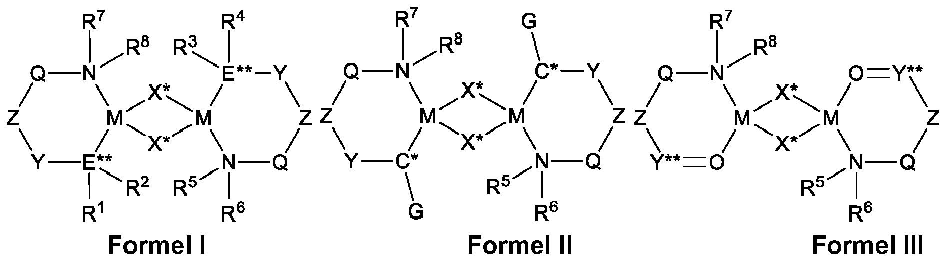 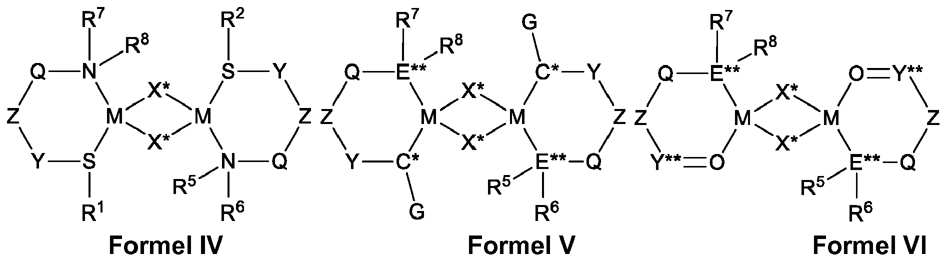 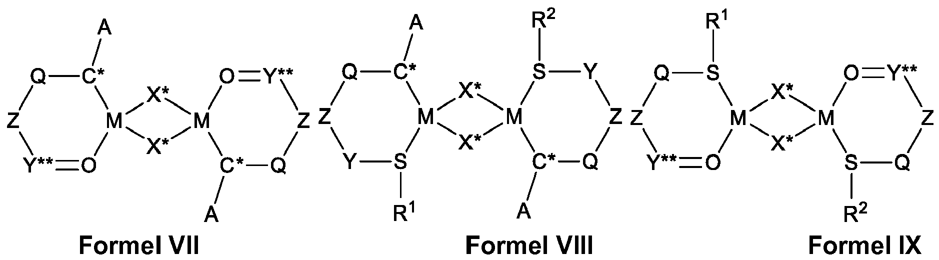 mit:
X* = unabhängig voneinander ausgewählt aus der Gruppe bestehend aus Cl, Br, I, CN, OCN, SCN, Alkinyl und N₃;
M = unabhängig voneinander ausgewählt aus der Gruppe bestehend aus Cu und Ag;
E** = unabhängig voneinander ausgewählt aus der Gruppe bestehend aus P, As und Sb;
C* = ein divalentes Carben-Kohlenstoffatom;
A und G = unabhängig voneinander Substituenten ausgewählt aus der Gruppe bestehend aus NRR', OR, SR und PRR' sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Q, Y und Z = unabhängig voneinander Substituenten ausgewählt aus der Gruppe bestehend aus NR, O, S und PR sowie Alkyl- (unverzweigt, verzweigt oder zyklisch), Heteroalkyl-, Aryl-, Heteroaryl-, Alkenyl-, Alkinyl-Gruppen oder substituierte Alkyl-(unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Y** = unabhängig voneinander ausgewählt aus der Gruppe bestehend aus CR, N, PRR', SR, S(O)R;
R und R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R¹-R⁸ = jeweils unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind; wobei die Reste R¹-R⁸ optional zu annelierten Ringsystemen führen.

3. Verwendung nach Anspruch 1 oder 2, wobei die Einheiten QC*A und YC*G unabhängig voneinander ausgewählt sind aus der Gruppe bestehend aus 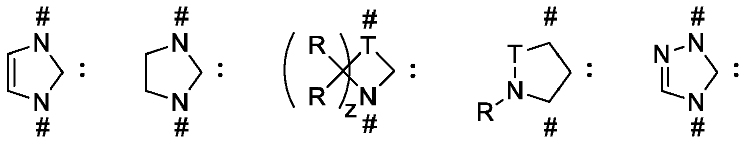 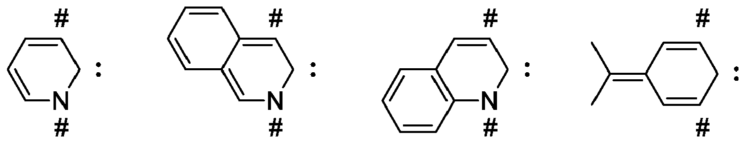 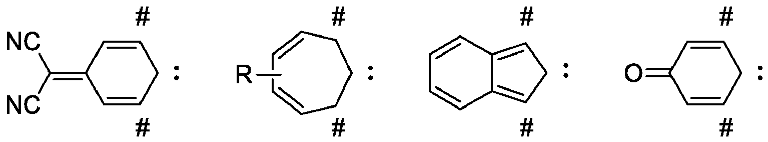 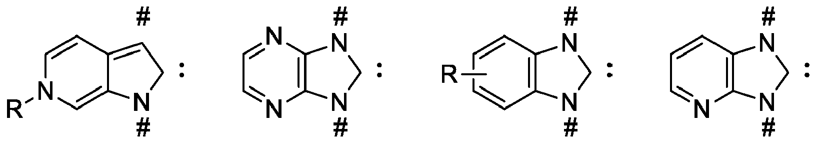 wobei
die zwei Punkte ":" für ein divalentes Carben-Kohlenstoffatom stehen, das an das Metall koordiniert, und die Verknüpfung von Q mit Z und die Verknüpfung von Y mit Z an einer der mit # gekennzeichneten Stellen stattfindet und somit A und G das andere Nachbaratom des Carben-Kohlenstoffatoms darstellt, das dann mit einem Rest R substituiert ist, der ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
jedes weitere R unabhängig voneinander ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
T ausgewählt ist aus der Gruppe bestehend aus CR₂, NR und SR, wobei jedes R unabhängig voneinander ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroaryl- Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
z für die ganzen Zahlen 1, 2, 3 oder 4 steht.

4. Verwendung nach Anspruch 1 bis 3, wobei EnD unabhängig voneinander ausgewählt ist aus der Gruppe bestehend aus 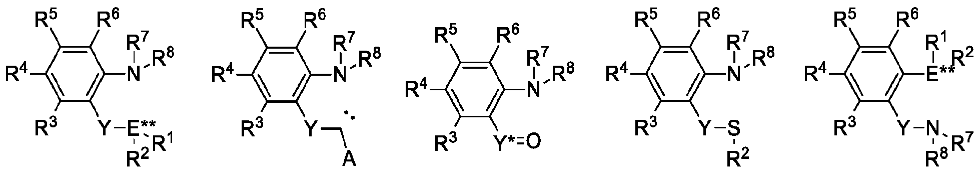 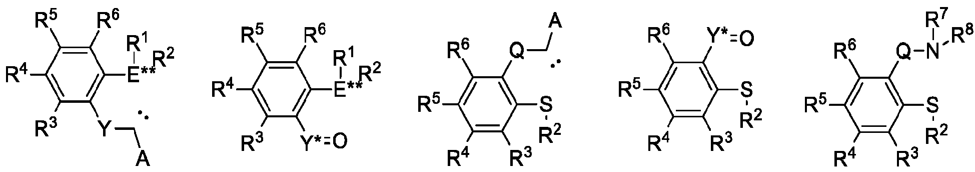 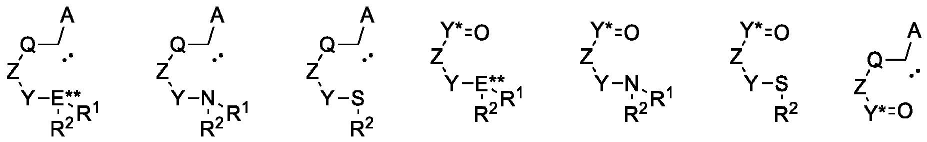 mit
E** = ausgewählt aus der Gruppe bestehend aus P, As und Sb;
: = ein Carben-Kohlenstoffatom;
A = Substituent ausgewählt aus der Gruppe bestehend aus NRR', OR, SR und PRR' sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Q, Y und Z = unabhängig voneinander Substituenten ausgewählt aus der Gruppe bestehend aus NR, O, S und PR sowie Alkyl- (unverzweigt, verzweigt oder zyklisch), Heteroalkyl-, Aryl-, Heteroaryl-, Alkenyl-, Alkinyl-Gruppen oder substituierte Alkyl-(unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind; wobei A und Q und G und Y optional jeweils miteinander verbunden sind, sodass sich ein Imidazolidin- oder ein Imidazolderivat ausbildet und/oder mit der Einheit Z und/oder den Resten R³-R⁸ zu annelierten Ringsystemen führt;
Y* = unabhängig voneinander ausgewählt aus der Gruppe bestehend aus CR, N, PRR', SR, S(O)R;
R und R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R¹-R⁸ können jeweils unabhängig voneinander ausgewählt aus der Gruppe bestehend aus Wasserstoff, Halogen sein und Substituenten, die direkt oder über Sauerstoff- (-OR), Stickstoff- (-NR₂) oder Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind; wobei R³-R⁸ optional zu annelierten Ringsystemen führen.

5. Verwendung nach Anspruch 1 bis 4, wobei die Herstellung des Metall(I)komplexes den folgenden Schritt umfasst:
Durchführen einer Reaktion von EnD mit M(I)X,
wobei
M = unabhängig voneinander ausgewählt aus der Gruppe bestehend aus Cu und Ag,
X = unabhängig voneinander ausgewählt aus der Gruppe bestehend aus Cl, Br, I, CN, OCN, SCN, Alkinyl und N₃;
E∩D = ein zweizähniger Ligand mit
E = RR'E* (wenn E* = N, P, As, Sb) oder RE* (wenn E* = C*, O, S) mit E* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
D = RR'D* (wenn D* = N, P, As, Sb) oder RD* (wenn D* = C*, O, S) mit D* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
wobei D und E verschieden voneinander sind.

6. Verwendung nach Anspruch 5, wobei die Reaktion in Dichlormethan oder Acetonitril oder Tetrahydrofuran oder Dimethylsulfoxid oder Ethanol durchgeführt wird.

7. Verwendung nach Anspruch 5 oder 6, weiterhin aufweisend den Schritt der Zugabe von Diethylether, Pentan, Hexan, Methyl-tert-butylether, Methanol, Ethanol und/oder Wasser zur Gewinnung des Metall(I)komplexes in Form eines Feststoffs.

8. Verwendung nach Anspruch 5 bis 7, weiterhin aufweisend den Schritt der Substitution mindestens eines Liganden EnD mit mindestens einer funktionellen Gruppe zur Verbesserung des Ladungsträgertransports, die ausgewählt ist aus Elektronenleiter und Lochleiter.

9. Verfahren zur Herstellung einer Organische Elektrolumineszenzvorrichtung, wobei ein in den Ansprüchen 1 bis 4 definierter Metall(I)komplex zur Herstellung einer Emitterschicht oder Absorberschicht mittels Vakuumverdampfung auf einen festen Träger aufgebracht wird.

10. Verfahren nach Anspruch 9, **dadurch gekennzeichnet, dass** eine oder mehrere Schichten mit einem Sublimationsverfahren beschichtet werden oder dass eine oder mehrere Schichten mit einem Organic Vapour Phase Deposition (OVPD) Verfahren oder mit Hilfe einer Trägergassublimation beschichtet werden.

11. Organische Elektrolumineszenzvorrichtung, herstellbar durch ein Verfahren nach Anspruch 9 oder 10.

12. Organische Elektrolumineszenzvorrichtung, **dadurch gekennzeichnet, dass** der in den Ansprüchen 1 bis 4 definierte Metall(I)komplex als Emissionsmaterial in einer Emissionsschicht eingesetzt wird, wobei er entweder zu 100 % als Reinschicht oder in Kombination mit einem Matrixmaterial eingesetzt wird.

13. Organische Elektrolumineszenzvorrichtung nach Anspruch 12 **dadurch gekennzeichnet, dass** der Anteil des in den Ansprüchen 1 bis 4 definierten Metall(I)komplexes als Emissionsmaterial in einer Emissionsschicht in optischen Licht emittierenden Bauelementen, insbesondere in OLEDs, zwischen 5 % und 80 % beträgt.

14. Organische Elektrolumineszenzvorrichtung nach Anspruch 12, **dadurch gekennzeichnet, dass** das Matrixmaterial für den in den Ansprüchen 1 bis 4 definierten Metall(I)komplex ausgewählt ist aus der Gruppe bestehend aus Ketonen, Phosphinoxiden, Sulfoxiden, Sulfonen, Triarylaminen, Carbazolderivaten, Phenoxazinderivaten, Phenothiazinderivaten, Indolocarbazolderivaten, Azacarbazolen, bipolaren Matrixmaterialien, aliphatisch-aromatischen Kohlenwasserstoffen, Silanen, Azaborolen, Boronestern, Triazinderivaten, Diazasilol- bzw. Tetraazasilol-Derivaten, Zinkkomplexen oder Mischungen aus zwei oder mehr dieser Matrixmaterialien.

15. Verfahren zur Veränderung der Emissions- und/oder Absorptionseigenschaften einer Organische Elektrolumineszenzvorrichtung, **gekennzeichnet durch** Einbringen eines in den Ansprüchen 1 bis 4 definierten Metall(I)komplexes mittels Vakuumverdampfung in ein Matrixmaterial, insbesondere zur Leitung von Elektronen und/oder Löchern in einer Organischen Elektrolumineszenzvorrichtung.

16. Lichtemittierendes Material, aufweisend einen in den Ansprüchen 1 bis 4 definierten Metall(I)komplex und ein Hostmaterial, wobei die Triplett (T1)- und Singulett (S1)-Energieniveaus des Hostmaterials energetisch höher liegen als die Triplett (T1)- und Singulett (S1)-Energieniveaus des in den Ansprüchen 1 bis 4 definierten Metall(I)komplexes, und wobei das lichtemittierende Material Fluoreszenz oder thermisch aktivierte verzögerte Fluoreszenz zeigt, und einen deltaE(S1-T1)-Wert zwischen dem untersten angeregten Singulett (S1)- und dem darunter liegenden Triplett (T1)-Zustand von kleiner als 2000 cm⁻¹ aufweist.

17. Verfahren zur Veränderung der Emissions- und/oder Absorptionseigenschaften eines elektronischen Bauelements, **gekennzeichnet durch** Einbringen eines in den Ansprüchen 1 bis 4 definierten Metall(I)komplexes mittels Vakuumverdampfung.
